(19) Europäisches Patentamt
European Patent Office
Office européen des brevets

(11) Publication number : 0 588 544 A2

# (12) EUROPEAN PATENT APPLICATION

(21) Application number : 93307020.3

(51) Int. Cl.$^5$ : G03F 7/039

(22) Date of filing : 06.09.93

(30) Priority : 14.09.92 JP 271014/92

(43) Date of publication of application : 23.03.94 Bulletin 94/12

(84) Designated Contracting States : DE FR GB

(71) Applicant : WAKO PURE CHEMICAL INDUSTRIES LTD
1-2 Doshomachi-3-chome
Chuo-ku Osaka (JP)

(71) Applicant : MATSUSHITA ELECTRIC INDUSTRIAL CO., LTD
1006, Oaza Kadoma, Kadoma-shi
Osaka 571 (JP)

(72) Inventor : Urano, Fumiyoshi, c/o Tokyo Kenkyusho
WAKO PURE CHEMICAL IND., LTD., 1633, Matoba
Kawagoe-shi (JP)

Inventor : Negishi, Takaaki, c/o Tokyo Kenkyusho
WAKO PURE CHEMICAL IND., LTD., 1633, Matoba
Kawagoe-shi (JP)

Inventor : Endo, Masayuki, c/o Handotai Kenkyusenta
MATSUSHITA ELEC.IND.CO.,LTD, 1-1 Yagumo Nakamachi-
3-chome, Moriguchi-shi (JP)

Inventor : Hashimoto, Kazuhiko, c/o Handotai Kenkyusenta
MATSUSHITA ELEC.IND.CO.,LTD, 1-1 Yagumo Nakamachi-
3-chome, Moriguchi-shi (JP)

Inventor : Katsuyama, Akiko, c/o Handotai Kenkyusenta
MATSUSHITA ELEC.IND.CO.,LTD, 1-1 Yagumo Nakamachi-
3-chome, Moriguchi-shi (JP)

(74) Representative : Baillie, Iain Cameron et al
c/o Ladas & Parry Altheimer Eck 2
D-80331 München (DE)

## (54) Fine pattern forming material and pattern formation process.

(57) A resist material comprising (a) a copolymer having as a functional group

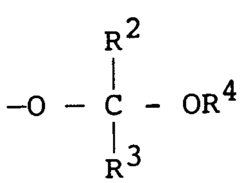

wherein $R^2$ and $R^3$ are, e.g. $C_{1-6}$ alkyl, and $R^4$ is, e.g. $C_{1-10}$ alkyl, (b) a compound which generates an acid when exposed to electron beams, and (c) a solvent, is suitable for forming a chemical-amplified positive-working fine pattern with high resolution and good shape.

EP 0 588 544 A2

## BACKGROUND OF THE INVENTION

This invention relates to a resist material used for producing patterns in semiconductor devices and integrated circuits (IC) applying electron beam lithographic technique, and to a process for forming fine patterns using such a resist material.

In the production of IC's and LSI's, lithography using ultraviolet light has been used for forming patterns. With a recent demand for producing finer elements and ASIC's, electron beam lithography is used more often. In the formation of fine patterns by the electron beam lithography, it is inevitable to use electron beam resists. As the positive-working electron resists, there has mainly been used poly(methyl methacrylate) (PMMA) as a skeleton due to good resolution. But since PMMA is low in sensitivity, the sensitivity has been improved by a process wherein electron attractive groups are introduced into side-chains so as to easily cut main chains, i.e. using, for example, poly(hexafluorobutyl methacrylate), poly(2,2,2-trichloroethyl methacrylate), etc. But these highly sensitized PMMA resist materials do not sufficiently satisfy both the sensitivity and the resolution. Further, in order to obtain higher sensitivity, resistance to dry etching and heat resistance are sacrified, resulting in making it difficult to use as a mask for dry etching and limiting its utility. In addition, in order to develop the positive-working resist obtained by using a polymer of one component such as the above-mentioned improved PMMA as a base, it is necessary to use an organic solvent. When the organic solvent is used, the resist film often swells in the organic solvent during the development, resulting in lowering the resolving power of patterns, and sometimes causing deformation of patterns so as to make the patterns impossible to use. Further the use of the organic solvent as a developer is not preferable from the viewpoints of environmental pollution, health and flammability.

Recently, in order to improve the sensitivity of positive-working electron beam resists, the concept of chemical amplification is introduced and there are a number of reports concerning this (e.g. H. Ito et al, SPIE vol. 1086, Advances in Resist Technology and Processing VI (1989) p. 11; H. Shiraishi et al., J. Vac. Sci. Technol., B9(6), p. 3343 (1991); Japanese Patent Unexamined Publication (JP-A) No. 3-192361; JP-A 4-155344; etc.). These resists contain multi-component substances such as a compound which generates an acid upon exposure to electron beams (herein after referred to as "acid generator"), and a compound which brings about an acid catalized reaction by such an acid, and are used as positive-working electron beam resists. As the acid generator, there are used triphenyl phosphonium salts, diphenyl iodonium salts, tris(trichloromethyl)-s-triazine/triethanolamine, sulfonic acid esters, etc. These acid generators generate strong acids, with high volatility such as Lewis acids or sulfonic acid. As polymers which are reacted with such acids, there are used poly(p-tert-butoxycarbonyloxystyrene), poly(p-tetrahydropyranyloxystyrene), poly(p-trimethylsilyloxystyrene), etc. These polymers bring about the following decomposition reaction by the acid generated by exposure to electron beams:

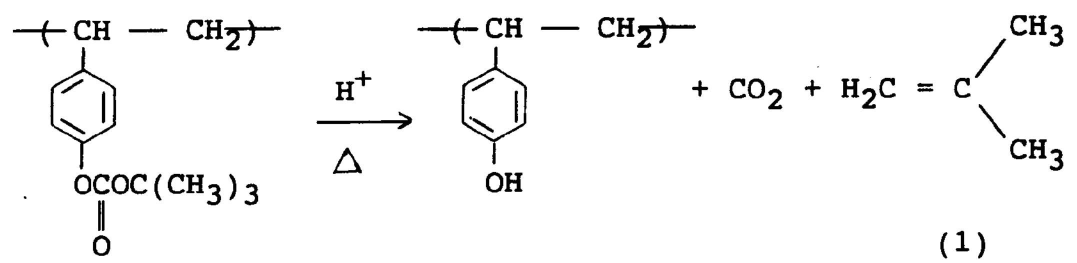


(1)

With the progress of the above-mentioned reaction, the decomposition reaction of protective group of the polymer proceeds. That is, by conducting imagewise electron beam exposure, an acid generator generates an acid, which can make an alkali-insoluble polymer alkali-soluble and form a positive-working pattern. Using such multi-component substances containing a matrix polymer and an acid generator as a resist, there is developed a process for forming a pattern comprising coating such a resist material on a semiconductor substrate, an organic plane film, or an inorganic intermediate film, exposing the resist material to electron beams, heat treating the resulting resist material, and developing the resulting resist material with an organic alkaline aqueous solution. But these polymers hardly release the protective groups. The positive-working resist to be used in the future should have a resolving power of 0.2 μm design rule or less and sufficient sensitivity as a resist, but such a resist is not found in chemical amplification type resists. Further, since these electron beam resists generate strong acids having high volatility in common, the generated acids are easily influenced by an atmosphere such as an amine. As a result, there arises a problem in that the pattern size changes during imagewise electron beam exposure, or in a period between the imagewise exposure to heat treatment. Further, in order to etch the substrate without dimensional shift using an etching mask, it is necessary to use a resist

pattern having a vertical shape. But from the above-mentioned polymer and acid generator, it is impossible to obtain a resist pattern having a good shape.

On the other hand, the PMMA-based resists have a problem of swelling and insufficiency in resistance to dry etching at the time of development as mentioned above, and are not suitable for fine processing of 0.2 μm design rule or less.

As mentioned above, application of chemical amplification to resists is effective for improving the sensitivity and removing the swelling caused by an organic developer, and influences on human bodies and environmental pollution, no positive-working resists satisfying both sensitivitry and resolution at the same time have been developed. Since the improvement in sensitivity in electron beam lithography leads to improvement in throughput, the improvement in the resist sensitivity is an important problem. Further, in order to use as a mask for dry etching, it is necessary to have sufficient resistance to dry etching at the same time. Further, there is also a big problem in that the pattern dimension changes during the imagewise electron beam exposure. Therefore, the development of positive-working electron beam resists overcoming these problems and practically usable have been desired.

## SUMMARY OF THE INVENTION

It is an object of the present invention to provide a resist material for providing a chemical-amplified positive-working electron beam resist having high sensitivity, high resolution and high dry etching resistance and capable of maintaining stable pattern dimension. It is another object of the present invention to provide a process for forming a fine pattern using such a resist material.

The present invention provides a resist material comprising

(a) a polymer represented by the formula:

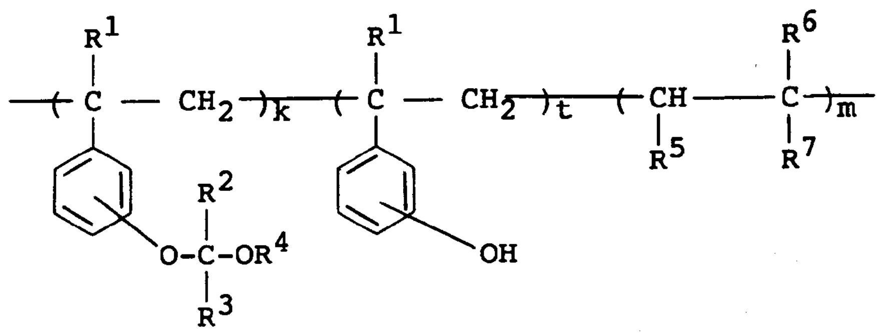

[I]

wherein $R^1$ is a hydrogen atom or a methyl group; $R^2$ and $R^3$ are independently a hydrogen atom or a straight, branched or cyclic alkyl group having 1 to 6 carbon atoms, provided that $R^2$ and $R^3$ cannot be hydrogen atoms at the same time, or $R^2$ and $R^3$ can form together a methylene linkage having 2 to 5 carbon atoms; $R^4$ is a straight, branched or cyclic alkyl group having 1 to 10 carbon atoms, a straight, branched or cyclic haloalkyl group having 1 to 6 carbon atoms, or an aralkyl group having 7 to 10 carbon atoms; $R^5$ is a hydrogen atom or a cyano group; $R^6$ is a hydrogen atom or a methyl group; $R^7$ is a hydrogen atom, a cyano group, -COOY in which Y is a straight, branched or cyclic alkyl group having 1 to 6 carbon atoms, or a group of the formula:

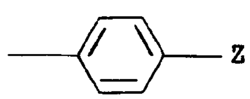

[II]

in which Z is a hydrogen atom, a halogen atom, a straight or branched alkyl group having 1 to 10 carbon atoms, or a straight, branched or cyclic alkoxy group having 1 to 10 carbon atoms, or $R^5$ and $R^7$ can form together a group of the formula: -CO - O - CO - ; k and t are independently an integer of 1 or more, provided that $0.1 \leqq k/(k+t) \leqq 0.9$; and m is zero or an integer of 1 or more, provided that when m is an integer of 1 or more, $0.05 \leqq m/(k+t+m) \leqq 0.50$,

(b) an acid generator which can generate an acid upon exposure to electron beams, and

(c) a solvent capable of dissolving the components (a) and (b).

The present invention also provide a process for forming a fine pattern, which comprises

(i) a step of coating the resist material mentioned above on a semiconductor substrate, followed by heat treatment for forming a resist film,

(ii) a step of exposing the resist film to electron beams to image a pattern, followed by heat treatment depending on necessity, and

(iii) a step of developing the resulting resist film with an alkaline aqueous solution to form a positive-working pattern.

The present invention further provides a process for forming a fine pattern, which comprises

(i) a step of coating an organic high polymer solution on a semiconductor substrate, followed by heat treatment to form an underlying film,

(ii) a step of forming an inorganic intermediate film on the underlying film,

(iii) coating the resist material mentioned above on the intermediate film, followed by heat treatment to form a resist film,

(iv) a step of exposing the resist film to electron beams to image a pattern, followed by heat treatment depending on necessity,

(v) a step of developing the resist film with an alkaline aqueous solution to form a positive-working pattern,

(vi) a step of masking the resulting resist pattern, followed by etching of the intermediate film, and

(vii) a step of masking the resulting pattern, followed by etching the underlying film.

## BRIEF DESCRIPTION OF THE DRAWINGS

Figs. 1A and 1B are cross-sectional views explaining the process for forming a fine pattern in Example 1.

Fig. 2 is a graph showing a sensitivity curve expressing a relationship between the normalized remaining film thickness obtained from the resist material and the dose in Example 1.

Fig. 3 is a graph showing a sensitivity curve expressing a relationship between the normalized remaining film thickness obtained from the resist material and the dose in Example 2.

Figs. 4A to 4D are cross-sectional views explaining the process for forming a fine pattern in Example 3.

Fig. 5 is a cross-sectional view showing a pattern with a undesirable adverse trapezoid obtained in Comparative Example 1.

## DESCRIPTION OF THE PREFERRED EMBODIMENTS

The chemical-amplified resist of the present invention is characterized by using as a resin component a polymer represented by the formula:

(a) a polymer represented by the formula:

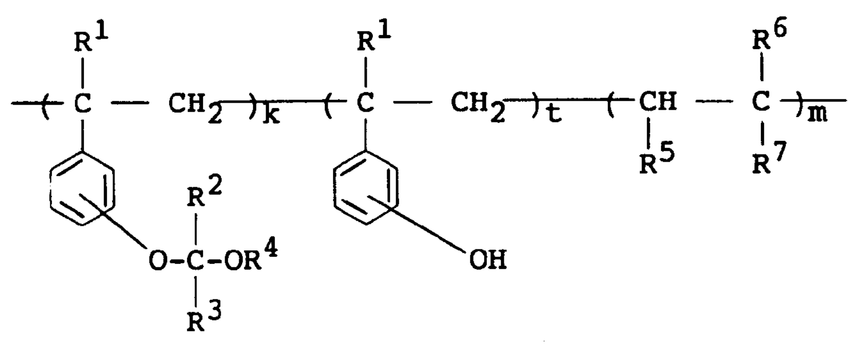

[I]

wherein $R^1$ is a hydrogen atom or a methyl group; $R^2$ and $R^3$ are independently a hydrogen atom or a straight, branched or cyclic alkyl group having 1 to 6 carbon atoms, provided that $R^2$ and $R^3$ cannot be hydrogen atoms at the same time; or $R^2$ and $R^3$ can form together a methylene linkage having 2 to 5 carbon atoms; $R^4$ is a straight, branched or cyclic alkyl group having 1 to 10 carbon atoms, a straight, branched or cyclic haloalkyl group having 1 to 6 carbon atoms, or an aralkyl group having 7 to 10 carbon atoms; $R^5$ is a hydrogen atom or a methyl group; $R^7$ is a hydrogen atom, a cyano group, -COOY in which Y is a straight, branched or cyclic alkyl group having 1 to 6 carbon atoms, or a group of the formula:

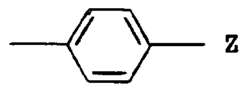

[II]

in which Z is a hydrogen atom, a halogen atom, a straight or branched alkyl group having 1 to 10 carbon atoms, or a straight, branched or cyclic alkoxy group having 1 to 10 carbon atoms, or $R^5$ and $R^7$ can form together a group of the formula: -CO-O-CO-; k and t are independently an integer of 1 or more, provided that $0.1 \leqq k/(k+t) \leqq 0.9$; and m is zero or an integer of 1 or more, provided that when m is an integer of 1 or more, $0.05 \leqq m/(k+t+m) \leqq 0.50$.

In the formula [I], the $C_{1-6}$ alkyl group defined in $R^2$ and $R^3$, the alkyl moiety in the $C_{1-6}$ haloalkyl group in the definition of $R^4$, and the $C_{1-6}$ alkyl group in Y in the group of -COOY in the definition of $R^7$, includes methyl, ethyl, propyl, butyl, amyl, and hexyl, either straight, branched or cyclic. The alkyl moiety in the $C_{1-10}$ alkoxy group in the definition of $R^4$, and the $C_{1-10}$ alkyl group and the alkyl moiety of $C_{1-10}$ alkoxy group in Z in the group:

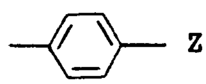

[II] in the definition of $R^7$, includes methyl, ethyl, propyl, butyl, amyl, hexyl, heptyl, octyl, nonyl and decyl, either straight, branched or cyclic. The halogen atom in $C_{1-6}$ haloalkyl in the definition of $R^4$ includes chlorine, bromine, fluorine and iodine. The aralkyl group in the definition of $R^4$ includes benzyl, phenethyl, phenylpropyl, methylbenzyl, methylphenethyl, ethylbenzyl, etc.

The polymer of the formula [I] has its most marked characteristics in that it comprises a monomer unit having a functional group which can be released by an acid and represented by the formula:

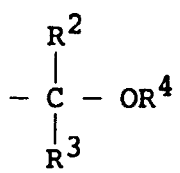

[VI]

wherein $R^2$, $R^3$ and $R^4$ are as defined above, for example, an alkoxyalkyl group, a haloalkoxyalkyl group or an aralkyloxyalkyl group, that is, the monomer unit represented by the formula:

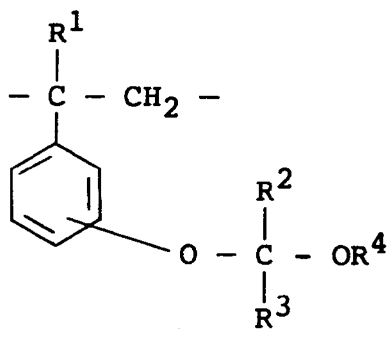

[VII]

wherein $R^1$, $R^2$, $R^3$ and $R^4$ are as defined above. Particularly, the functional group represented by the formula [VI] has a higher electron density at the functional group site due to electron donating properties of alkoxy group than known functional groups such as a tert-butoxycarbonyl group, a tert-butyl group, a trimethylsilyl group, or a tetrahydropyranyl group similar to these groups, so that the decomposition reaction remarkably easily proceeds by a small amount of acid. Since the chemical amplification proceeds by a small dose, the sensitivity is enhanced compared with known positive-working resists, resulting in making it possible to increase the productivity remarkably. Further, the polymer of the formula [I] is also advantageous for improving the resolution

and maintaining the pattern dimension.

The monomer unit represented by the formula [VII] is derived from a monomer such as a p- or m-hydroxystyrene derivative, a p- or m-hydroxy-α-methylstyrene derivative or the like having a functional group of the formula:

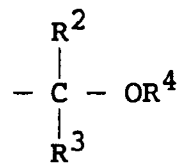

[VI]

Examples of such a monomer having a functional group of the formula [VI] are p- or m-1-methoxy-1-methylethoxystyrene, p- or m-1-benzyloxy-1-methylethoxystyrene, p- or m-1-ethoxyethoxystyrene, p- or m-1-methoxyethoxystyrene, p- or m-1-n-butoxyethoxystyrene, p- or m-1-isobutoxyethoxystyrene, p- or m-1-(1,1-dimethylethoxy)-1-methylethoxystyrene, p- or m-1-(1,1-dimethylethoxy)ethoxystyrene, p- or m-1-(2-chloroethoxy)ethoxystyrene, p- or m-1-cyclohexyloxyethoxystyrene, p- or m-1-(2-ethylhexyloxy)ethoxystyrene, p- or m-1-ethoxy-1-methylethoxystyrene, p- or m-1-n-propoxyethoxyethoxystyrene, p- or m-1-ethoxypropoxystyrene, p- or m-1-methoxybutoxystyrene, p- or m-1-methoxycyclohexyloxystyrene, and p- or m-hydroxy-α-methylstyrene derivatives having the same protective group as those mentioned above as to the p- or m-hydroxystyrene derivatives. These monomers can be used singly or as a mixture thereof.

Among these monomers, those having alkyl groups in the definitions of $R^2$ and $R^3$, respectively, in the formula:

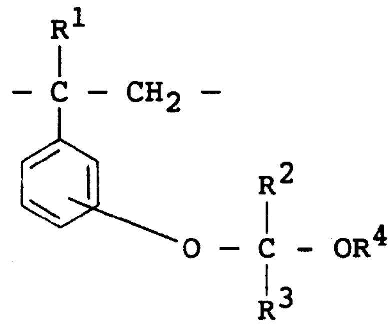

[VII]

for example, p- or m-1-methoxy-1-methylethoxystyrene, p- or m-1-benzyloxy-1-methylethoxystyrene, p- or m-1-(1,1-dimethylethoxy)-1-methylethoxystyrene, p- or m-1-ethoxy-1-methylethoxystyrene, p- or m-1-methyl-1-n-propoxyethoxystyrene, etc. are more preferable, since the protective group can remarkably easily be released by the action of the acid to improve the resolution capacity, which is one object of the present invention.

The polymer of the formula [I] includes a monomer unit of the formula:

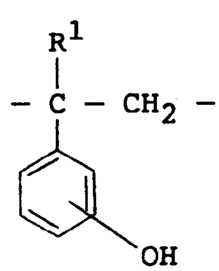

[VIII]

wherein $R^1$ is as defined above, and, if necessary, a monomer unit of the formula:

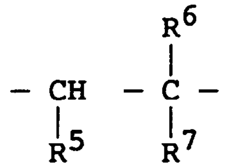

[IX]

wherein $R^5$, $R^6$ and $R^7$ are as defined above, in addition to the monomer unit of the formula [VII].

The monomer unit of the formula [VIII] is derived from a monomer having a phenolic hydroxyl group, for exmaple, p- or m-vinylphenol, p- or m-hydroxy-α-methylstyrene, etc. Such monomers can be used singly or as a mixture thereof.

The monomer unit of the formula [IX] is derived from a monomer such as acrylonitrile, fumaronitrile, methyl methacrylate, tert-butyl methacrylate, maleic anhydride, p-tert-butoxystyrene, p-methylstyrene, p-chlorostyrene, styrene, etc. Such monomers can be used singly or as a mixture thereof.

In the polymer of the formula [I], the monomer unit of the formula [VII] and that of the formula [VIII] are present preferably in the molar ratio of 1:9 to 9:1, more preferably 2:8 to 7:3 considering the heat resistance of the polymer and excellent adhesiveness to the semiconductor substrate.

Examples of the polymer of the formula [I] are as follows:

poly(p-1-methoxy-1-methylethoxystyrene-p-hydroxystyrene),
poly(p-1-benzyloxy-1-methylethoxystyrene-p-hydroxystyrene),
poly(p-1-ethoxyethoxystyrene-p-hydroxystyrene),
poly(p-1-methoxyethoxystyrene-p-hydroxystyrene),
poly(p-1-n-butoxyethoxystyrene-p-hydroxystyrene),
poly(p-1-isobutoxyethoxystyrene-p-hydroxystyrene),
poly[p-1-(1,1-dimethylethoxy)-1-methylethoxystyrene-p-hydroxystyrene],
poly[m-1-(2-chloroethoxy)ethoxystyrene-m-hydroxystyrene],
poly(p-1-cyclohexyloxyethoxystyrene-p-hydroxystyrene),
poly[m-1-(2-ethylhexyloxy)ethoxystyrene-m-hydroxystyrene],
poly(p-1-methoxy-1-methylethoxy-α-methyl-styrene-p-hydroxy-α-methylstyrene),
poly(p-1-ethoxyethoxystyrene-p-hydroxystyrene-acrylonitrile),
poly(p-1-ethoxyethoxystyrene-p-hydroxystyrene-fumaronitrile),
poly(p-1-n-butoxyethoxystyrene-p-hydroxystyrene-methyl methcrylate),
poly(p-1-cyclohexyl-1-ethoxyethoxystyrene-p-hydroxystyrene-tert-butyl methacrylate),
poly(p-1-methoxycyclohexylostyrene-p-hydroxystyrene),
poly(p-1-ethoxy-1-methylethoxystyrene-p-hydroxystyrene),
poly(p-1-ethoxyethoxystyrene-p-hydroxystyrene-p-tert-butoxystyrene),
poly(p-1-methoxyethoxystyrene-p-hydroxystyrene-p-methylstyrene),
poly(p-1-ethoxyethoxystyrene-p-hydroxystyrene-p-chlorostyrene),
poly[p-1-(2-chloroethoxy)ethoxystyrene-p-hydroxystyrene-tert-butyl methacrylate],
poly(m-1-cyclohexyloxyethoxystyrene-m-hydroxystyrene-maleic anhydride), etc.

The polymer of the formula [I] can eassily be produced by the following four processess of a) to d).

a) Process-1

A monomer of the formula:

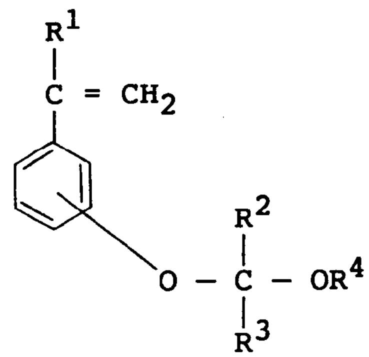

[X]

wherein $R^1$, $R^2$, $R^3$ and $R^4$ are as defined above, having the functional group of the formula:

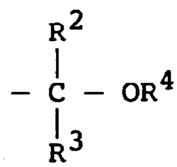

[VI]

alone or together with a third monomer is polymeried by a conventional method in an organic solvent such as benzene, toluene, tetrahydrofuran, 1,4-dioxane, etc. in the presence of a radical polymerization initator in a stream of argon or nitrogen at 50 to 110°C for 1 to 10 hours. As the radical polymerization initiator, there can be used an azo compound such as 2,2'-azobisisobutyronitrile, 2,2'-azobis(2,4-dimethylvaleronitrile), 2,2'-azobis(methyl 2-methylpropionate), etc.; a peroxide compound such as benzoyl peroxide, lauroyl peroxide, etc. After the reaction, a homopolymer comprising the monomer unit of the formula [VII] or a copolymer including the monomer unit of the formula [VII] is isolated after a conventional aftertreatment. The resulting homopolymer or copolymer is reacted with a suitable acid such as a Lewis acid, e.g. sulfuric acid, phosphoric acid, hydrochloric acid, or hydrobromic acid, or an organic acid, e.g. p-toluenesulfonic acid, malonic acid, or oxalic acid, in an organic solvent such as tetrahydrofuran, acetone, 1,4-dioxane, etc. at 30 to 100°C for 1 to 10 hours to remove the functional group of the formula:

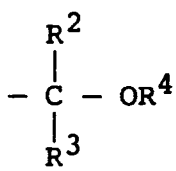

[VI]

in an optional proportion. After the reaction, the resulting polymer is treated by a conventional method for obtaining a polymer to isolate the desired polymer.

b) Process-2

A monomer of the formula [X], p- or m-hydroxystyrene, or p- or m-hydroxy-α-methylstyrene, and, if necessary, a third monomer are copolymerized in the same manner as described in the Process-1 mentioned above, followed by isolation of the desired polymer by a conventional aftertreatment.

c) Process-3

Commercially available p-tert-butoxystyrene alone or together with a third monomer is polymerized in the same manner as described in the Process-1 mentioned above to produce poly(p-tert-butoxystyrene) or a copolymer including p-tert-butoxystyrene units. The resulting polymer or copolymer is then reacted with a suitable acid (e.g. a Lewis acid such as sulfuric acid, phosphoric acid, hydrochloric acid, hydrobromic acid, etc.; or an

organic acid such as p-toluenesulfonic acid, malonic acid, oxalic acid, etc.) in an organic solvent such as tetrahydrofuran, acetone, 1,4-dioxane, etc., at 30 to 110°C for 1 to 20 hours to remove the functional group of tert-butyl group completely or partially in optional proportions to produce poly(p-hydroxystyrene), poly(p-tert-butoxystyrene-p-hydroxystyrene) or a copolymer including monomer units of the formula:

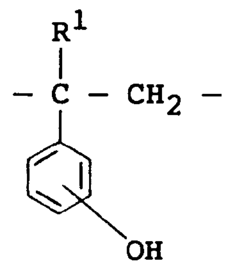 [VIII]

The resulting polymer or copolymer is reacted with a vinyl ether compound or an isopropenyl ether compound of the formula:

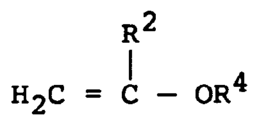 [XI]

wherein $R^2$ and $R^4$ are as defined above, in an organic acid such as tetrahydrofuran, acetone, 1,4-dioxane, methylene chloride, dimethoxyethane, etc. in the presence of a suitable acid (e.g. sulfuric acid, hydrochloric acid, p-toluenesulfonic acid, pyridine salt of chlorosulfonic acid, pyridine salt of sulfuric acid, pyridine salt of p-toluenesulfonic acid, etc.) at 10 to 100°C for 1 to 20 hours to chemically introduce the functional group of the formula:

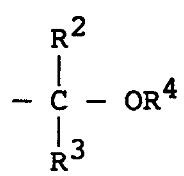 [VI]

into the polymer or copolymer in a desired proportion followed by a conventional aftertreatment for obtaining a polymer to isolate the desired polymer.

d) Process-4

Commercially available poly(p-hydroxystyrene) or copolymer including monomer units of the formula:

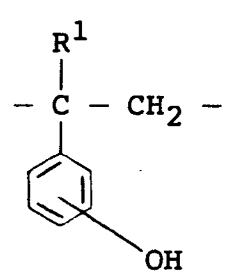 [VIII]

is reacted with a vinyl ether compound or an isopropenyl ether compound of the formula:

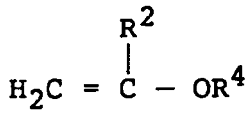

[XI]

in a desired proportion in the same manner as described in the Process-3, followed by a conventional aftertreatment for obtaining a polymer to isolate the desired polymer.

The polymer of the formula [I] has a molecular weight suitable as a resist material, preferably a weight-average molecular weight of about 1000 to 50000, more preferably about 3000 to 40000, measured by GPC method using polystyrene as standard.

As the acid generator (b) which generates an acid by exposure to electron beams, there can be used those which give no bad influence on resist pattern formation. Needless to say, it is preferable to use of compounds which generate an acid effectively when exposed to electron beams.

Particularly preferable examples of the acid generators are as follows:

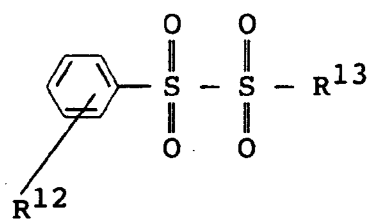

[III]

wherein $R^{12}$ is a hydrogen atom, a halogen atom, a straight, branched or cyclic alkyl group having 1 to 10 carbon atoms or a straight, branched or cyclic alkoxy group having 1 to 10 carbon atoms; and $R^{13}$ is a straight, branched or cyclic alkyl group having 1 to 8 carbon atom, a phenyl group, an alkyl-substituted phenyl group, a halogen-substituted phenyl group, a benzyl group or an alkoxy-substituted phenyl group.

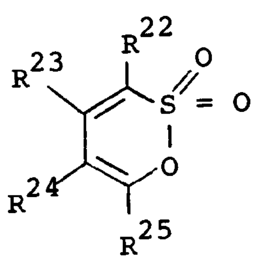

[IV]

wherein $R^{22}$, $R^{23}$, $R^{24}$ and $R^{25}$ are independently a hydrogen atom, a halogen atom, a straight, branched or cyclic alkyl group having 1 to 10 carbon atoms, a haloalkyl group having 1 to 10 carbon atoms, an alkoxyalkyl group having 2 to 10 carbon atoms, an aralkyl group having 7 to 10 carbon atoms, a phenyl group, a substituted phenyl group (substituted being one or more halogen atoms, straight, branched or cyclic alkyl groups having 1 to 10 carbon atoms, straight, branched or cyclic alkoxy groups having 1 to 10 carbon atoms, nitro groups or cyano groups), and $R^{22}$ together with $R^{23}$, $R^{23}$ together with $R^{24}$, and $R^{24}$ teogether with $R^{25}$, can indepdependently form an alicyclic ring, a heteroalicyclic ring, an aromatic ring or a heteroaromatic ring.

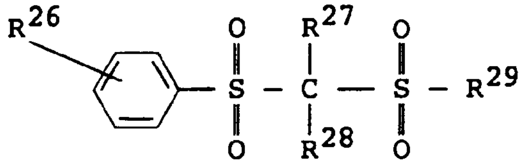

[V]

wherein $R^{26}$ is a hydrogen atom, a halogen atom, a straight, branched or cyclic alkyl group having 1 to 10 carbon atoms, or a straight, branched or cyclic alkoxy group having 1 to 10 carbon atoms; $R^{27}$ is a hydrogen atom, or an alkyl group having 1 to 3 carbon atoms; $R^{28}$ is an alkyl group having 1 to 3 carbon atoms; and $R^{29}$ is a straight,

branched or cyclic alkyl group having 1 to 10 carbon atoms, an aralkyl group having 7 to 10 carbon atoms, a phenyl group, a substituted phenyl group (substituent being one or more halogen atoms, straight, branched or cyclic alkyl groups having 1 to 10 carbon atoms or straight, branched or cyclic alkoxy groups having 1 to 10 carbon atoms).

Preferable examples of the acid generator (6) are as follows:

diphenyldisulfone,
di(p-tolyl)disulfone,
p-tolyl phenyldisulfone,
p-tolyl n-butyldisulfone,
p-tolyl isopropyldisulfone,
p-tolyl n-octyldisulfone,
p-tolyl benzyldisulfone,
p-methoxyphenyl p-tolyldisulfone,
p-methoxyphenyl phenyldisulfone,
p-chlorophenyl p-tolyldisulfone,
p-chlorophenyl phenyldisulfone,
p-methoxyphenyl n-butyldisulfone,
p-methoxyphenyl isopropyldisulfone,
phenyl n-butyldisulfone,
phenyl isopropyldisulfone,
phenyl n-octyldisulfone,
phenyl benzyldisulfone,
di(p-methoxyphenyl) disulfone,
di(p-chlorophenyl) disulfone,
p-tolyl ethyldisulfone,
p-methoxyphenyl ethyldisulfone,
4,6-dimethyl-1,2-oxathiin-2,2-dioxide,
4,6-diphenyl-1,2-oxathiin-2,2-dioxide,
4-methyl-6-phenyl-1,2-oxathiin-2,2-dioxide,
3-bromo-4,6-dimethyl-1,2-oxathiin-2,2-dioxide,
6-(4-bromophenyl)-1,2-oxathiin-2,2-dioxide,
6-phenyl-1,2-oxathiin-2,2-dioxide,
6-(4-tolyl)-1,2-oxathiin-2,2-dioxide,
3-phenyl-5,6,7,8-tetrahydro-2,1-benzoxathiin-1,1-dioxide,
2,2-bis-benzenesulfonylpropane,
2-(p-toluenesulfonyl)-2-methylsulfonylpropane,
2-(p-toluenesulfonyl)-2-cyclohexylsulfonyl propane,
2-benzenesulfonyl-2-(1,1-dimethylethylsulfonyl)propane,
2-[(1,1-dimethylethyl)phenylsulfonyl]-2-(1-methylethylsulfonyl)propane,
2,2-bis(p-toluenesulfonyl)butane,etc.

On the other hand, known acid generators other than those mentioned above, such as triphenylsulfonium salts, diphenyliodonium salts, pyrogallol tris(methanesulfonate), and tris(trichloromethyl)-s-triazine/triethanol amine, etc. are not preferable as the acid generator for chemical amplified resist materials, since a strong acid such as a Lewis acid having high volatility is generated upon exposure to electron beams, so that the acid vaporises from the resist film surface during or after imagewise exposure to electron beams, or is remarkably influenced by an atmosphere such as an amine gas atmosphere. As a result, during the imagewise exposure, or with the lapse of time from the imagewise exposure to development, there arise problems in that the so-called T-shaped or overhang profiles in the formation of pattern often take place, the pattern forming dimension changes largely, or no pattern is formed completely.

As the solvent (c), there can be used those which can dissolve both the components (a) and (b), and are good in film-forming properties.

Preferable examples of the solvent are methyl Cellosolve acetate, ethyl Cellosolve acetate, propylene glycol monoethyl ether acetate, propylene glycol monomethyl ether acetate, methyl lactate, ethyl lactate, 2-ethoxyethyl acetate, methyl pyrurate, ethyl pyrurate, methyl 3-methoxypropionate, ethyl 3-methoxypropionate, N-methyl-2-pyrrolidone, cyclohexanone, methyl ethyl ketone, 1,4-dioxane, ethylene glycol monoisopropyl ether, diethylene glycol monoethyl ether, diethylene glycol monomethyl ether, diethylene glycol dimethyl ether, etc. These solvents can be used alone or as a mixture thereof.

The resist material of the present invention may further contain one or more dyes such as fluorenone derivatives, anthracene derivatives, acridine compounds, pyrene derivatives, etc.; electroconductive compounds such as polypyrrole, TCNQ complexes, etc.; surfactants, and the like additives.

Using the resist material mentioned above, fine patterns can be formd as follows.

The present invention also provide a process for forming a fine pattern, which comprises

(i) a step of coating the resist material mentioned above on a semiconductor substrate, followed by heat treatment for forming a resist film,

(ii) a step of exposing the resist film to electron beams to image a pattern, followed by heat treatment depending on necessity, and

(iii) a step of developing the resulting resist film with an alkaline aqueous solution to form a positive-working pattern.

The present invention further provides a process for forming a fine pattern, which comprises

(i) a step of coating an organic high polymer solution on a semiconductor substrate, followed by heat treatment to form an underlying film,

(ii) a step of forming an inorganic intermediate film on the underlying film,

(iii) coating the resist material mentioned above on the intermediate film, followed by heat treatment to form a resist film,

(iv) a step of exposing the resist film to electron beams to image a pattern, followed by heat treatment depending on necessity,

(v) a step of developing the resist film with an alkaline aqueous solution to form a positive-working pattern,

(vi) a step of masking the resulting resist pattern, followed by etching of the intermediate film, and

(vii) a step of masking the resulting pattern, followed by etching the underlying film.

More concretely, fine patterns can be formed as follows.

The resist material of the present invention is spin coated on a substrate such as a silicon wafer so as to make the film thickness about 0.5 to 2 μm after dried, and prebaked in an oven at 70 to 130°C for 10 to 30 minutes, or on a hot plate at 70 to 130°C for 1 to 2 minutes. After imagewise exposure to electron beams at an accelerating voltage of 20 to 50 KeV, and an exposure dose of 0.1 to 100 $\mu C/cm^2$, the resulting film is baked on a hot plate at 70 to 150°C for 1 to 2 minutes. Then, using a developing solution such as an aqueous solution of 0.1 to 5% tetramethylammonium hydroxide (TMAH), the development is carried out for about 0.5 to 3 minutes by a conventional method such as a dip method, a puddle method, a spray method, etc., to form the desired pattern on the substrate.

On the other hand, influences of back scattering of electron beams can be prevented by forming an organic underlying film on a substrate, forming an inorganic intermediate film on the underlying film, forming a resist pattern on the intermediate film, and transferring the pattern. As the organic underlying film, it is preferable to use, for example, a novolak resin which is usually used as a resist material for i-line and g-line, so as to obtain a pattern having good resistance to etching. As the inorganic intermediate film, it is preferable to use a silicon oxide film or a SOG (spin on glass which is a film obtained by coating solution obtained by dissolving an organic silicone compound in an organic solvent, drying and heating to covert it to silicon oxide) so as to attain easy film formation, small dimensional shift at the time of underlying film etching and precise pattern transfer.

The resist material of the present invention preferably contains 1 part by weight of the polymer (a) and 0.01 to 0.3 part by weight, more preferably 0.01 to 0.1 part by weight, of the acid generator (b) in the case of positive-working resist material. The amount of the solvent (c) is not particularly limited so long as no troubles are caused at the time of coating the positive-working resist material containing the polymer (a) and the acid generator (b). Usually, the solvent is used in an amount of 1 to 20 parts by weight, preferably 1.5 to 6 parts by weight per part by weight of the polymer (a).

As the developing solution, it is preferable to use an alkaline solution having a suitable concentration so as almost not to dissolve unexposed portions and so as to dissolve exposed portions, depending on the solubility of the polymer (a) used in the resist material. Usually, the concentration of alkaline developer is preferably 0.01 to 20% by weight. As the alkaline developing solution, there can be used a solution of organic amine such as TMAH, choline, triethanolamine, etc.; an inorganic alkali such as NaOH, KOH, etc.

In the present invention, since the polymer (a) contains the monomer unit represented by the formula:

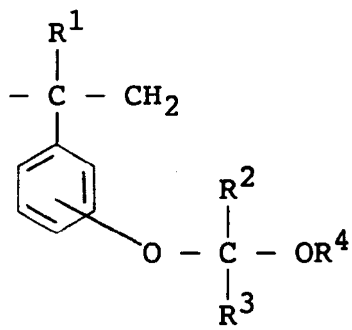

[VII]

including the functional group of the formula:

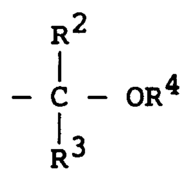

[VI]

the functional group can more easily be removed in the presence of an acid so as to more easily become alkali-soluble compared with known polymers used for the same purpose. Thus, it becomes possible to maintain the pattern dimension stably during exposure to electron beams or a period between the exposure to electron beams and heat treatment (baking). Further, since the polymer

(a) contain the hydroxystyrene unit of the formula:

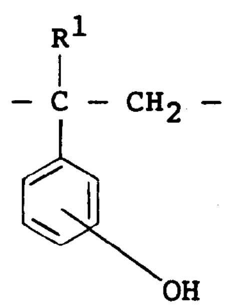

[VIII]

the heat resistance, resistance to dry etching and adhesiveness to the substrate are also excellent.

In contrast, when $R^2$ and $R^3$ in the formula [I] are hydrogen atoms (e.g. in the case of p-alkoxymethoxystyrene), the resist material is used as a negative-working resist material, not applicable to the positive-working resist material.

The resist material of the present invention comprising an acid generator of the formula [III], [IV] or [V] can generate an acid when exposed to not only electron beams but also KrF excimer laser light (248.4 nm) and X-rays and shows chemical amplification action. Therefore, the resist material of the present invention can be used for pattern formation applying chemical amplification not only using a low dose of electron beams but also using deep UV light such as KrF excimer laser light or X-rays.

Action of the present invention is explained concretely. The area exposed to electron beams generates an acid by the reactions shown by the following Equations (2), (3) or (4):

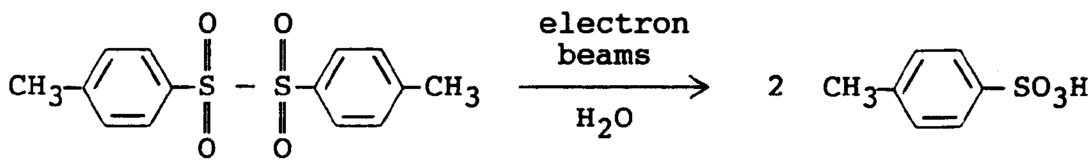


(2)

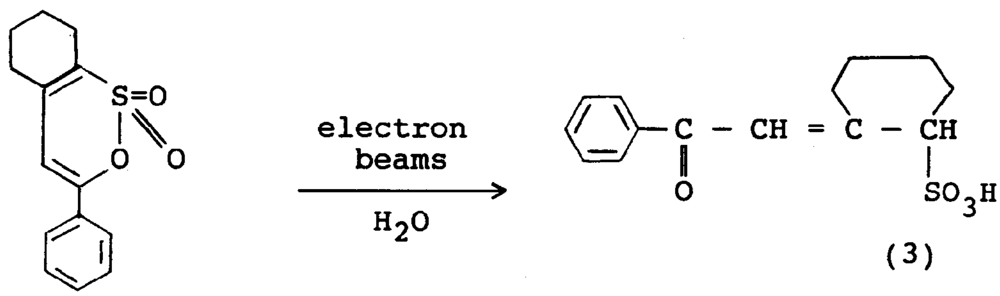


(3)

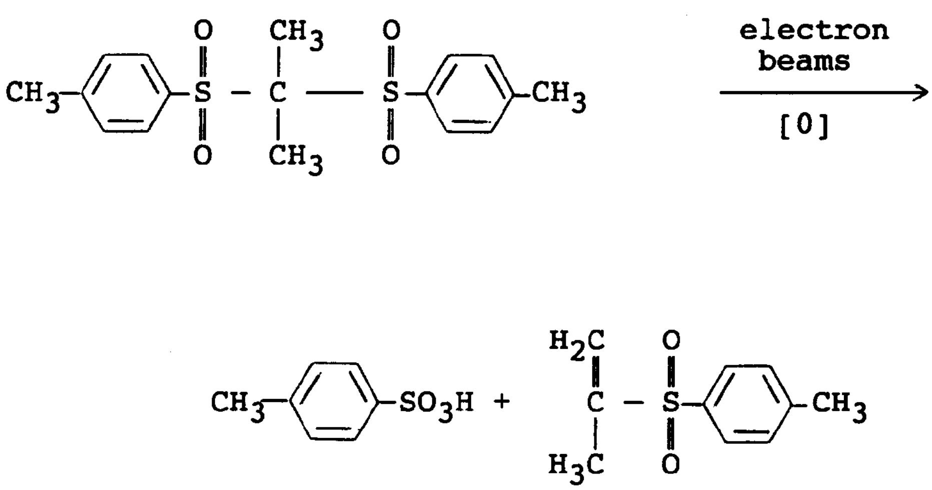


(4)

The heat treatment subsequent to the irradiation step causes the chemical reaction as shown by Equation (5) to change the special functional group of the polymer (a) [1-ethoxyethoxy group in the Equation (5)] to a hydroxyl group by the action of the acid so as to make the polymer alkali-soluble, resulting in releasing into the developing solution at the time of development;

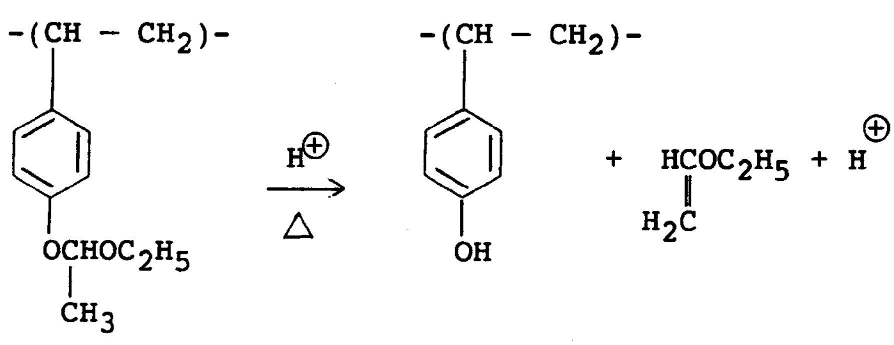


(5)

On the other hand, since no acid is generated on the non-exposed area, no chemical change takes place even if subjected to heat treatment. Rather, the hydrophilic sites of the polymer used for the purpose of strengthening adhesiveness to the substrate are protected by the acid generator from the swelling by the alkaline developing solution. As mentioned above, since a large difference in the solubility in the alkaline developing solution takes place between the exposed area and the non-exposed area when a pattern is formed by using the resist material of the present invention, and since the non-exposed area of the polymer has strong adhesiveness to the substrate, no peeling of the film takes place at the time of development. As a result, a positive-working pattern having good contrast can be formed. Further, as shown in the Equation (5), since the acid generated by exposure to electron beams acts catalytically, it is sufficient to generate the acid in a small amount only necessary for the reaction, resulting in reducing the energy amount of irradiation of electron beams. In addition, since an organic alkaline aqueous solution can be used as a developing solution, no swelling of developer takes place and no harm is given to the circumstances and human bodies.

The present invention is illustrated by way of the following Examples, in which all parts and percents are by weight, unless otherwise specified.

Synthesis Example 1 Synthesis of poly[p-(1-ethoxyethoxy)styrene/p-hydroxystyrene] [Method 1]

(1) Synthesis of p-bromo-(1-ethoxyethoxy)benzene

p-Bromophenol (50 g, 0.29 mole), ethyl vinyl ether (41.7 g, 0.58 mole) and pyridinium p-toluenesulfonate (1.5 g) were dissolved in methylene chloride (300 ml), followed by reaction with stirring at room temperature for 6 hours. Then 5% aqueous sodium bicarbonate (400 ml) was added to the reaction mixture, and stirred. Then, the organic layer was separated, washed with $H_2O$ (300 ml x 3), dried over anhydrous $MgSO_4$ and evaporated. The residue (82 g) was distilled under reduced pressure to give 71.1 g of p-bromo-(1-ethoxyethoxy)benzene as a pale yellow oil having a boiling point of 112 - 114°C/6 mmHg. (798Pa)

$^1$HNMR δ ppm ($CDCl_3$): 1.20 (3H, t, J=7Hz, -$CH_2$-C$\underline{H}_3$), 1.49 (3H, d, J=5.1Hz, -OCH-C$\underline{H}_3$), 3.47 - 3.83 (2H, m, -C$\underline{H}_2$$CH_3$), 5.31 - 5.37 (1H, q, J=5.5Hz, OC$\underline{H}$$CH_3$), 6.95 (2H, d, J=8.8Hz, Aromatic 2-H, 6-H), 7.32 (2H, d, J=8.8Hz, Aromatic 3-H, 5-H).

IR(Neat) ν $cm^{-1}$: 2970, 2930, 2890, 1595, 1490.

(2) Synthesis of p-(1-ethoxyethoxy)styrene

To a suspension of magnesium turning (3.7 g, 0.15 atom) in dry tetrahydrofuran (30 ml) under nitrogen, a solution of p-bromo-(1-ethoxyethoxy)benzene (35 g, 0.14 mole) obtained in above (1) in dry tetrahydrofuran (150 ml) was added dropwise under mild reflux, followed by reaction with stirring for 1 hour under reflux.

After cooling to 10°C, dichloro(1,2-bis-(diphenylphosphino)ethane}nickel (0.8 g) was added to the reaction mixture, then a solution of vinyl bromide (15.3 g, 0.14 mole) in dry tetranydrofuran (50 ml) was added dropwise at 20 - 30° under nitrogen and continued to stir at room temperature for 1 hour. To the reaction mixture, aqueous ammonium chloride (200 ml) and methylene chloride (200 ml) were added, followed by stirring. Then, the organic layer was separated, washed with $H_2O$ (200 ml x 2), dried over anhydrous $MgS0_4$ and evaporated. The remaining oil (30 g) was purified by fractional distillation under reduced pressure in the presence of a few milligrams of tert-butylcatechol as an inhibitor. There was obtained 21.5 g of p-(1-ethoxyethoxy)styrene as a colorless oil having a boiling point of 93 - 96°C/1 mmHg. (133Pa)

$^1$HNMR δ ppm ($CDCl_3$): 1.20 (3H, t, J=7Hz, -$CH_2$C$\underline{H}_3$), 1.50 (3H, d, J=5H.1Hz, OCHC$\underline{H}_3$), 3.49 - 3.85 (2H, m, -C$\underline{H}_2$$CH_3$), 5.13 (1H, d, J=10.6Hz, C$\underline{H}_2$= CH-), 5.35 - 5.41 (1H, q, J=5.5hz, O$\underline{CH}$$CH_3$), 5.62 (1H, q, J=17.6Hz, C$\underline{H}_2$=CH-), 6.66 (1H, dd, J=10.6Hz and J=17.6Hz, $CH_2$=C$\underline{H}$-), 6.95 (2H, d, J=8.8Hz, Aromatic 3-H, 5-H), 7.33 (2H, d, J=8.8Hz, Aromatic 2-H, 6-H).

IR(Neat) ν $cm^{-1}$: 2970, 2930, 2890, 1635 (C=C) 1605, 1505.

Anal. calcd. for $C_{12}H_{16}O_2$: C%, 74.97; H%, 8.39.
Found: C%, 75.08; H%, 8.33.

(3) Free radical polymerization of p-(1-ethoxyethoxy)styrene

A solution of p-(1-ethoxyethoxy)styrene (19.2 g) obtained in above (2) in toluene containing catalytic amount of 2,2'-azobisisobutyronitrile (AIBN) was polymerized at 80°C for 6 hours under nitrogen. After cooling, the reaction mixture was poured into methanol (1 liter) with stirring, standed, and then decanted. The resultant viscous oil was washed twice with methanol (500 ml) and concentrated under reduced pressure to give 16.3 g of poly[p-(1-ethoxyethoxy)styrene] as a pale yellow viscous oil having Mw 10000 and Mn 5500 (GPC with polystyrene calibration).

(4) Synthesis of poly[p-(1-ethoxyethoxy)styrene/p-hydroxystyrene]

A solution of poly[p-(1-ethoxyethoxy)styrene] (15.5 g) obtained in above (3) and oxalic acid (1.6 g) in 1,4-dioxane (150 ml) was reflux for 3 hours with stirring. The mixture was cooled, poured into $H_2O$ (1 liter) and the solid was precipitated. The precipitate was filtered, washed with $H_2O$ and dried under reduced pressure to afford 12.0 g of the title compound as a white powder having Mw 8500, Mw/Mn ≒ ca. 1.8 (GPC with polystyrene calibration). The polymer was found to have P-(1-ethoxyethoxy)styrene unit and p-hydroxystyrene unit in a molar ratio of ca. 1:1 based on $^1$HNMR analysis (with calibration using the methine proton at $\delta$ 5.25 - 5.4 ppm and the aromatic proton at $\delta$ 6.2 - 6.8 ppm in the $^1$HNMR spectrum.)

Synthesis Example 2 Synthesis of poly[p-(1-ethoxy ethoxy)styrene/p-hydroxystyrene] [Method 2]

Using p-(1-ethoxyethoxy)styrene (9.6 g) obtained in Synthesis Example 1, (2) and p-hydroxystyrene (6.0 g), free radical polymerization was carried out in the same manner as described in Synthesis Example 1, (3). Then the reaction mixture was poured into petroleum ether (1 liter), and the precipitate was filtered, washed and dried in vacuo to afford 12.8 g of the title compound as a white powder having Mw 9000 and Mw/Mn = 2.0 (GPC with polystyrene calibration). The polymer was found to have p-(1-ethoxyethoxy) styrene unit and p-hydroxystyrene unit in a molar ratio of ca. 1:1 based on $^1$HNMR.

Synthesis Example 3 Synthesis of poly[p-(1-ethoxyethoxy)styrene/p-hydroxystyrene] [Method 3]

(1) Free radical polymerization of p-tert-butoxystyrene

A solution of p-tert-butoxystyrene (17.6 g) in toluene containing catalytic amount of 2,2'-azobisisobutyronitrile (AIBN) kwas polymerized at 80°C for 6 hours under nitrogen. After cooling, the reaction mixture was poured into methanol (1 liter) and the polymer was precipitated. The polymer was filtered, washed with methanol and dried under reduced pressure to afford 15.5 g of poly(p-tert-butoxystyrene) as a white powder having Mw 10000 (GPC kwith polystyrene calibration).

(2) Synthesis of poly(p-hydroxystyrene)

A solution of poly(p-tert-butoxystyrene) (15.0 g) obtained in above (1) and conc. hydrochloric acid (10 ml) in 1,4-dioxane was refluxed for 4 hours with stirring. The mixture was cooled, poured into $H_2O$ (1 liter) and the solid was precipitated. The polymer was filtered, washed with $H_2O$ and dried under reduced pressure to give 9.7 g of poly(p-hydroxystyrene) as a white powder.

(3) Synthesis of poly[p-(1-ethoxyethoxy)styrene/p-hydroxystyrene]

To a solution of poly(p-dydroxystyrene) (4.0 g) obtained in above (2) and ethyl vinyl ether (1.5 g) in a mixed solvent (35 ml) of pyridine and 1.4-dioxane, a catalytic amount of p-toluenesulfonic acid was added and reacted with stirring at room temperature for 24 hours. The reaction mixture was poured into $H_2O$ (1 liter) and a white solid was precipitated. The polymer was filtered, washed with $H_2O$ and dried under reduced pressure to afford 5.0 g of the desired product as a white powder having Mw 10000 (GPC with polystyrene calibration). The polymer was found to have p-(1-ethoxyethoxy)styrene unit and p-hydroxystyrene unit in a molar ratio of ca. 1:1 based on $^1$HNNR.

Synthesis Example 4 Synthesis of poly[p-(1-ethoxy ethoxy)styrene/p-hydroxystyrene] [Method 4]

A solution of poly(p-hydroxystyrene) (8.0 g) [MARUKA LYNCUR-M, manufactured by Maruzene Petrochemical Co.,Ltd., having Mw 10000 and Mn 5000], ethyl vinyl ether (3.0 g) and pyridinium p-toluenesulfonate (0.5 g) in dioxane (70 ml) was reacted with stirring at room temperature for 24 hours. After reaction, the mixture was poured into $H_2O$, was precipitated with stirring, and the precipitate was filtered, washed with $H_2O$ and then dried in vacuo. There was obtained 10.0 g of the desired product as a white powder having Mw 11000 (GPC with polystyrene calibration). The polymer was found to have p-(1-ethoxyethoxy)styrene unit and p-hydroxystyrene unit in a molar ratio of ca. 1:1 based on $^1$HNMR.

Synthesis Example 5 Synthesis of poly[P-(1-ethoxyethoxy)styrene/p-hydroxystyrene]

To a solution of poly(p-hydroxystyrene) (4.0 g) obtained in Synthesis Example 3, (2) and ethyl vinyl ether (1.5 g) in acetone, a catalytic amount of pyridinium p-toluenesulfonate was added, and reacted with stirring at room temperature for 12 hours. The reaction mixture was poured into $H_2O$ (1 liter) and was precipitated. The precipitate was filtered, washed with $H_2O$ and dried under reduced pressure to give 3.9 g of the desired product as a white powder having Mw 10000 (GPC with polystyrene calibration). The polymer was found to have p-(1-ethoxyethoxy)styrene unit and p-hydroxystyrene unit in a molar ratio of ca. 35:65 based on $^1$HNMR.

Synthesis Example 6 Synthesis of poly[p-(1-methoxyethoxy)styrene/p-hydroxystyrene) [Method 1]

(1) Synthesis of p-bromo-(1-methoxyethoxy)benzene

Using p-bromophenol (17.3 g, 0.1 mole) and methyl vinyl ether (14.0 g, 0.2 mole), the reaction was carried out in the same manner as described in Synethsis Example 1, (1), and the crude oil (24 g) was purified by distillation under reduced pressure to afford 20.8 g of p-bromo-(1-methoxyethoxy)benzene as a pale yellow oil having a boiling point 89 - 90°C/2 mmHg, (266 Pa)

$^1$HNMR δ ppm ($CDCl_3$): 1.46 (3H, d, J=5Hz, OCHC$\underline{H_3}$), 3.37 (3H, s, -$OCH_3$), 5.29 (1H, q, J=5.5Hz, O$\underline{CH}$$CH_3$), 6.86 (2H, d, J=8.8Hz, Aromatic 2-H, 6-H), 7.36 (2H, d, J=8.8Hz, Aromatic 3-H, 5-H).

IR(Neat) ν $cm^{-1}$: 3000, 2940, 2850, 1590, 1580, 1490.

(2) Synthesis of p-(1-methoxyethoxy)styrene

Using p-bromo-(1-methoxyethoxy)benzene (11.6 g) obtained in above (1), the reaction was carried out in the same manner as described in Synthesis Example 1, (2), and the crude oil (10.7 g) was distilled under reduced pressure in the presence of a few milligrams of p-tert-butylcatechol as an inhibitor to give 8.8 g of p-(1-methoxyethoxy)styrene as a colorless oil having a boiling point of 86 - 87°C/3 mmHg. (399Pa)

$^1$HNMR δ ppm ($CDCl_3$): 1.46 (3H, d, J=5.5Hz, OCHC$\underline{H_3}$), 3.37 (3H, s, C$\underline{H_3}$), 5.12 (1H, d, J=11Hz, C$\underline{H_2}$=CH-), 5.30 (1H, q, J=5.1Hz and J=5.5Hz, O$\underline{CH}$$CH_3$), 5.60 (1H, d, J=17.6Hz, C$\underline{H_2}$=CH-), 6.64 (1H, dd, J=11Hz and J=17.6Hz, $CH_2$=C$\underline{H}$-), 6.95 (2H, d, J=8.8Hz, Aromatic 3-H, 5-H), 7.32 (2H, d, J=8.8Hz, Aromatic 2-H, 6-H).

IR(Neat) ν $cm^{-1}$: 2980, 2920, 2820, 1620 (C=O), 1600, 1500.

Anal. calcd. for $C_{11}H_{14}O_2$: C%, 74.13; H%, 7.92.

Found: C%, 74.41; H%, 7.88.

(3) Free radical polymerization of p-(1-methoxyethoxy)styrene

Using P-(1-methoxyethoxy)styrene (8.0 g) obtained in above (2), the polymerization was carried out in the same manner as described in Synthesis Example 1, (3), and the resultant viscous oil was washed with methanol and concentrated in vacuo to give 7.2 g of poly(1-methoxyethoxy)styrene as a pale yellow viscous oil having Mw 10000 and Mn 5000 (GPC with polystyrene calibration).

(4) Synthesis of poly[p-(1-methoxyethoxy)styrene/p-hydroxystyrene]

Using poly(1-methoxyethoxy)styrene (6.2 g) obtained in above (3), the reaction was carried out in the same manner as described in Synthesis Example 1, (4) to afford 3.0 g of the title compound as a white powder having Mw 9000 and Mw/Mn ≒ 1.8 (GPC with polystyrene calibration). The composition of the polymer was found to be p-(l-methoxyethoxy)styrene unit and p-hydroxystyrene unit in a molar ratio of ca. 45:55 based on $^1$HNMR.

Synthesis Example 7 Synthesis of poly[p-(1-methoxy-1-methylethoxy)styrene/p-hydroxystyrene]

To a solution of poly(p-hydroxystyrene) (4.0 g) obtained in the same manner as described in Synthesis Example 3, (2) and 2-methoxy-1-propene (4.8 g) in a mixed solvent (35 ml) of pyridine and 1,4-dioxane, a catalytic amount of chlorosulfonic acid was added and then reacted with stirring at room temperature for 20 hours. After reaction, the reaction was carried out in the same manner as described in Synthesis Example 3, (3) to give 4.1 g of poly[p-(1-methoxy-1-methylethoxy)styrene/p-hydroxystyrene as a white powder having Mw 10000 (GPC with polystyrene calibration). The composition of the polymer was found to be p-(1-methoxy-1-methoxy)styrene unit and p-hydroxystyrene unit in a molar ratio of ca. 1:1 based on $^1$HNMR.

Synthesis Example 8 Synthesis of poly[p-(1-n-butoxy ethoxy)styrene/p-hydroxystyrene]

To a solution of poly(p-hydroxystyrene) (4.8 g) obtained in the same manner as described in Synthesis Example 3, (2) and n-butyl vinyl ether (3.0 g) in a mixed solvent (50 ml) of pyridine and 1,4-dioxane, a catalytic amount of conc. sulfuric acid was added, then continued to stir at room temperature for 16 hours. The reaction mixture was treated in the same manner as described in Synthesis Example 3, (3) to give 4.2 g of poly[p-(1-n-butoxyethoxy)styrene/p-hydroxystyrene] as a white powder having Mw 10000 (GPC with polystyrene calibration). The composition of the polymer was found to be p-(1-n-butoxyethoxy)styrene unit and p-hydroxystyrene unit in a molar ratio of 4:6 based on $^1$HNMR.

Synthesis Example 9 Synthesis of poly[p-(1-ethoxyethoxy)styrene/p-hydroxystyrene/fumaronitrile]

(1) Free radical polymerization of p-tert-butoxystyrene and fumaronitrile

A solution of p-tert-butoxystyrene (28.2 g, 0.16 mole) and fumaronitrile (3.1 g, 0.04 mole) in toluene containing catalytic amount of 2,2'-azobis(methyl 2-methylpropionate) was heated at 90°C for 2 hours under nitrogen. After reaction, the reaction mixture was poured into methanol to precipitate a polymer. The polymer was filtered, washed and dried in vacuo to give 21.3 g of poly(p-tert-butoxystyrene-fumaronitrile) as a white powder.

(2) Synthesis of poly(p-hydroxystyrene/fumaronitrile)

Using poly(p-tert-butoxystyrene/fumaronitrile) (20.0 g) obtained in above (1), the reaction was carried out in the same manner as described in Synthesis Example 3, (2) to afford 10.6 g of the desired product as a white powder having Mw 10000 (GPC with polystyrene calibration).

(3) Synthesis of poly[p-(1-ethoxyethoxy)styrene/p-hydroxystyrene/fumaronitrile]

Using poly(p-hydroxystyrene/fumaronitrile) (9.0 g) obtained in above (2) and ethyl vinyl ether (3.0 g), the reaction was carried out in the same manner as described in Synthesis Example 3, (3) to give 8.8 g of the desired product as a white powder having Mw 11000 (GPC with polystyrene calibration). The composition of the polymer was found to be p-(1-ethoxyethoxy)styrene unit and p-hydroxystyrene unit in a molar ratio of ca. 4:6 based on $^1$HNMR.

Synthesis Example 10 Synthesis of poly[p-(1-ethoxyethoxy)styrene/p-hydroxystyrene/tert-butyl methacrylate]

(1) Free radical polymerization of p-(1-ethoxyethoxy) styrene and tert-butyl methacrylate]

A solution of p-(1-ethoxyethoxy)styrene (17.3 g, 0.09 mole) obtained in Synthesis Example 1, (2) and tert-butyl methacrylate (1.4 g, 0.01 mole) in toluene containing catalytic amount of 2,2'-azobis(methyl 2,4-dimethylpropionate) was heated at 80°C for 8 hours under nitrogen. After cooling, the reaction mixture was poured into petroleum ether with stirring, standed, and then decanted. The resultant viscous oil was washed twice with methanol (500 ml) and concentrated under reduced pressure to give 15.5 g of poly[p-(1-ethoxyethoxy)-styrene/tert-butyl methacrylate] as a pale yellow viscous oil having Mw 12000 (GPC with polystyrene calibration).

(2) Synthesis of poly[p-(1-ethoxyethoxy)styrene/p-hydroxystyrene/tert-butyl methacrylate]

A solution of poly[p-(1-ethoxyethoxy)styrene/tert-butyl methacrylate] (12.0 g) obtained in above (1) in 1,4-dioxane, was added with p-toluenesulfonic acid (0.5 g) and reacted with stirring at 80°C for 30 minutes. After cooling, the reaction mixture was poured into $H_2O$ (1 liter) to precipitate a polymer. The polymer was filtered by suction, washed with $H_2O$ and dried in vacuo to give 9.8 g of the desired product as a white powder having Mw 11000 (GPC with polystyrene calibration). The composition of the polymer was found to be p-(1-ethoxyethoxy)styrene unit and p-hydroxystyrene unit in a molar ratio of ca. 35:65 based on $^1$HNMR analysis.

Synthesis Example 11 Synthesis of poly[p-(1-ethoxyethoxy)styrene/p-hydroxystyrene]

(1) Free radical polymerization of p-(1-ethoxyethoxy) styrene

A solution of p-(1-ethoxyethoxy)styrene (19.2 g) obtained in Synthesis Example 1, (2) in 1,4-dioxane containing catalytic amount of 2,2'-azobis(methyl 2-methylpropionate) was polymerized at 80°C for 3 hours and then 90°C for 4 hours under nitrogen. After cooling, the reaction mixture was poured into methanol (1000 ml) with stirring, standed, and then decanted. The resultant viscous oil was washed twice with methanhol (500 ml) and concentrated under reduced pressure to give 18.5 g of poly[p-(1-ethoxyethoxy)styrene] as a pale yellow viscous oil having Mw 25000 (GPC with polystyrene calibration).

(2) Synthesis of poly[p-(1-ethoxyethoxy)styrene/p-hydroxystyrene]

Using poly[p-(1-ethoxyethoxy)styrene] (16.5 g) obtained in above (1), the polymerization and treatment were carried out in the same manner as described in Synthesis Example 1, (4) to give 13.5 g of the title compound as a white powder having Mw ca. 22000 (GPC with polystyrene calibration). The polymer was found to have p-(1-ethoxyethoxy)styrene unit and p-hydroxystyrene unit in a molar ratio of ca. 35:65 based on $^1$HNMR analysis.

Synthesis Example 12 Synthesis of poly[p-(1-ethoxyethoxy)styrene/p-tert-butoxystyrene/p-hydroxystyrene]

(1) Synthesis of poly(p-tert-butoxystyrene/p-hydroxystyrene)

To a solution of poly(p-tert-butoxystyrene) (20 g) obtained in Synthesis Example 3, (1) in 1,4-dioxane, conc. HCl (4 ml) was added and refluxed with stirring for 2 hours. After cooling, the treatment was carried out in the same manner as described in Synthesis Example 3, (2) to afford 12.0 g of the title compound as a white powder. The polymer was found to have p-tert-butoxystyrene unit and p-hydroxystyrene unit in a molar ratio of ca. 1:9 based on $^1$HNMR analysis.

(2) Synthesis of poly[p-(1-ethoxyethoxy)styrene/p-tert-butoxystyrene/p-hydroxystyrene]

Using poly(p-tert-butoxystyrene/p-hydroxystyrene) (6.3 g) obtained in above (1) and ethyl vinyl ether (1.0 g), the reaction and treatment were carried out in the same manner as described in Synthesis Example 3, (3) to give 4.6 g of the title compound as a white powder having Mw ca. 10000 (GPC with polystyrene calibration). The polymer was found to have p-(1-ethoxyethoxy)styrene unit, p-tert-butoxystyrene unit and p-hydroxystyrene unit in a moalr ratio of ca. 25:10:65 based on $^1$HNMR analysis.

Reference Example 1 Synthesis of poly(p-tetrahydro-pyranylstyrene/p-hydroxystyrene)

To a solution of poly(p-hydroxystyrene) (9.0 g) [MARUKA LYNCUR-M, manufctured by Maruzen Petrochemical Co., Ltd., Mw 10000 and Mn 5000] in dimethoxyethane (100 ml), 3,4-dihydro-2H-pyran (12.6 g) and conc. sulfuric acid (0.5 ml) were added, followed by reaction at 30 - 40°C for 15 hours with stirring. After reaction, the mixture was evaporated in vacuo, the residue was neutralized by addition of sodium carbonate and poured into $H_2O$ (1 liter). The precipitate was filtered by suction, washed with $H_2O$ and dried under reduced pressure to give 11.0 g of the title compound as a white powder having Mw 10000 (GPC with polystyrene calibration). The composition of the polymer was found to be p-tetrahydropyranyloxystyrene unit and p-hydroxystyrene unit in a molar ratio of ca. 3:7 based on $^1$HNMR.

Reference Example 2 Synthesis of poly(p-tert-butoxystyrene/p-hydroxystyrene)

To a solution of poly(p-hydroxystyrene) (4.0 g) [MARUKA LYNCUR-M, manufactured by Maruzen petrochemical Co., Ltd., Mw 10000 and Mn 5000] in dimethoxyethane (70 ml) in a pressure vessel, isobutyrene (60 g) and conc. sulfuric acid (0.3 g) were added at -60°C or lower. The mixture was brought to 45°C for 1 hour with stirring, and then stirring was continued at room temperature for 22 hours. After reaction, the mixture was evaporated, and the residue was neutralized by sodium carbonate and poured into $H_2O$. The precipitate was filtered by suction, washed was $H_2O$ and dried in vacuo to give 4.1 g of poly(p-tert-butoxystyrene/p-hydroxystyrene) as a white powder having Mw 10000 (GPC with polystyrene calibration). $^1$HNMR analysis indicated that 50% of p-hydroxy group was converted into p-tert-butoxy group.

Reference Example 3 Synthesis of poly(p-tert-butoxy carbonyloxystyrene/p-hydroxystyrene)

(1) A solution of p-tert-butoxycarbonyloxystyrene (22 g, 0.1 mole) obtained by the method of USP 4,491,628 (1985) in toluene containing catalytic amount of 2,2'-azobis(2,4-dimethylvaleronitrile) was heated at 90°C for 4 hours under nitrogen. After cooling, the reaction mixture was poured into methanol and polymer was precipitated. The polymer was filtered, washed with methanol and dried under reduced pressure to give 15.2 g of poly(p-tert-butoxycarbonyloxystyrene) as a white powder having Mw 12000 (GPC with polystyrene calibration).

(2) To a solution of poly(p-tert-butoxycarbonyloxystyrene) (7.0 g) obtained in above (1) in 1,4-dioxane, conc. hydrochloric acid (5 ml) was added and continued to stir under reflux for 1.5 hours. After cooling, the reaction mixture-was poured into $H_2O$ (1 liter) and the polymer was precipitated. The polymer was filtered by suction, washed with $H_2O$ and dried in vacuo to afford 4.8 g of poly(p-tert-butoxycarbonyloxystyrene/p-hydroxystyrene) as a white powder having Mw 9500 (GPC with polystyrene calibration). The composition of the polymer was found to be p-tert-butoxycarbonyloxystyrene unit and p-hydroxystyrene unit in a molar ratio of ca. 1:1 based on $^1$HNMR analysis.

Reference Example 4 Synthesis of diphenyldisulfone

Sodium benzenesulfinate dihydrate (100 g, 0.5 mole) was added in a small portion to 5% aqueous HCl at room temperature, continued to stir for 30 minutes at the same temperature and the precipitate was filtered off. A solution of triethylamine (42.6 g, 0.42 mole) in water (85 ml) was added dropwise to the filtrate at 5°C or lower, and then benzenesulfonyl chloride (88.3 g, 0.42 mole) was added dropwise to the mixture at 0 - 5°C, continued to react with stirring for 30 minutes at room temperature. After reaction, the precipitate was filtered and washed with water. The resultant solid (38 g, wet) was recrystallized from benzene to give 7.2 g of diphenyldisulfone as prisms having a melting point of 188.5 - 190.0°C.

$^1$HNMR $\delta$ ppm ($CDCl_3$): 7.65 - 8.05 (10H, m, Aromatic)

IR(KBr) $\nu$ $cm^{-1}$: 1580, 1440, 1340, 1330, 1300

Reference Example 5 Synthesis of p-tolyl phenyl disulfone

Using sodium p-toluenesulfinate in place of sodium benzenesulfinate dihydrate, the reaction and treatment were carried out in the same manner as described in Reference Example 4. The resultant crude solid was recrystallized from benzene to afford 9.5 g of p-tolyl phenyl disulfone as prisms having a melting point of 153.5 - 154.5°C.

$^1$HNMR $\delta$ ppm ($CDCl_3$): 2.51 (3H, s, C$\underline{H_3}$), 7.43 (2H, d, J=8Hz, p-Tolyl ring 2-H, 6-H), 7.55 - 7.98 (7H, m, p-Tolyl ring 3-H, 5-H and Phenyl ring).

IR(KBr) $\nu$ $cm^{-1}$: 1595, 1450, 1348

Reference Example 6 Synthesis of di p-tolyl disulfone

Using sodium p-toluenesulfinate (22.3 g, 0.125 mole) and p-toluenesulfonyl chloride (23.8 g, 0.12 mole), the reaction and treatment were carried out in the same manner as described in Reference Example 4. The resultant crude solid was recrystallized from toluene to give 9.3 g of di p-tolyl disulfone as prisms having a melting point of 204.5 - 205°C.

$^1$HNMR $\delta$ ppm ($CDCl_3$): 2.51 (6H, s, C$\underline{H_3}$), 7.43 (4H, d, J=8.4Hz, Aromatic (2-H, 6-H) x 2), 7.84 (4H, d, J=8.4Hz, Aromatic (3-H, 5-H) x 2).

IR(KBr) $\nu$ $cm^{-1}$: 1345

Reference Example 7 Synthesis of p-tolyl n-butyl disulfone

(1) Synthesis of p-toluenesulfonylhydrazide

To a solution of p-toluenesulfonyl chloride (40 g) in tetrahydrofuran (70 ml), 85% hydrazine hydrate (27 ml) was added dropwise at 10 - 15°C, continued with stirring for 30 minutes at the same temperature, and the precipitate was filtered. The precipitate was recrystallized from methanol to give 15.8 g of p-toluenesulfonylhydrazide as white crystals having a melting point of 109 - 112°C.

$^1$HNMR $\delta$ ppm ($CDCl_3$): 2.35 (3H, s, C$\underline{H_3}$), 4.26 (2H, bs, -NH$\underline{NH_2}$), 7.38 (2H, d, J=8Hz, Aromatic 3-H, 5-H), 7.67 (2H, d, J=8Hz, Aromatic 2-H, 6-H), 8-28 (1H, bs, -$\underline{NH}NH_2$) .

IR(KBr) ν $cm^{-1}$: 3388, 3262, 1315.

(2) Synthesis of N-p-toluenesulfonyl-N'-n-butylsulfonylhyrazine

To a solution of p-toluenesulfonylhydrazide (4.66 g, 0.025 mole) obtained in above (1) in pyridine (5 ml), n-butylsulfonyl chloride (3.92 g, 0.025 mole) was added dropwise at 3 - 8°C, continued with stirring for 30 minutes at 10 - 15°C, and standed overnight at 15 - 20°C. The reaction mixture was poured into dil. HCl (1000 ml), and the precipitate was filtered, and recrystallized from toluene to afford 4.84 g of N-p-toluenesulfonyl-N'-n-butylsulfonylhydrazine as white crystals having a melting point of 124 - 126.5°C.

$^1$HNMR δ ppm ($CDCl_3$): 0.86 (3H, t, J=7.3Hz, $\underline{CH_3}$ $CH_2$ $CH_2$ $CH_2$-), 1.28 - 1.44 (2H, m, $CH_3$ $\underline{CH_2}$ $CH_2$ $CH_2$-), 1.54 - 1.68 (2H, m, $CH_3$ $CH_2$ $\underline{CH_2}$ $CH_2$-), 2.39 (3H, s, $\underline{CH_3}$), 3.00 (2H, t, J=7.6Hz, $SO_2$ $\underline{CH_2}$ $CH_2$-), 7.42 (2H, d, J=8Hz, Aromatic 3-H, 5-H), 7.69 (2H, d, J=8Hz, Aromatic 2-H, 6-H), 9.21 (1H, bs, -NH$\underline{NH}$$SO_2$ $CH_2$-, 9.92 (1H, bs, $\underline{NH}$NH$SO_2$ $CH_2$ $CH_2$-).

IR(KBr) ν $cm^{-1}$: 3236, 3192, 1330.

(3) Synthesis of Synthesis of p-tolyl n-pbutyl disulfone

To N-toluenesulfonyl-N'-n-butylsulfonylhydrazine (1 g, 3.26 mmole) obtlained in above (2), 65% nitric acid (1.9 g, 19.5 mmole) was added dropwise at 10°C or below, and continued to stir for 1 hour at 5 - 10°C. The reaction mixture was poured into ice-cold $H_2O$. The precipitate was filtered, washed with $H_2O$ and dried under reduced pressure. The crude solid (0.3 g) was recrystallized from n-hexane (15 ml)/ethyl acetate (3 ml) to give 0.2 g of p-tolyl n-butyl disulfone as white needles having a melting point of 67.5 - 70.0°C.

$^1$HNMR δ ppm (DMSO-$d_6$): 0.87 (3H, t, J=7.3Hz, $\underline{CH_3}$ $CH_2$ $CH_2$ $CH_2$-), 1.33 - 1.49 (2H, m, $CH_3$ $\underline{CH_2}$ $CH_2$ $CH_2$-), 1.67 - 1.82 (2H, m, $CH_3$, $CH_2$ $\underline{CH_2}$ $CH_2$-), 2.49 (3H, s, $\underline{CH_3}$), 3.69 (2H, t, J=7.6Hz, $SO_2$ $\underline{CH_2}$ $CH_2$-), 7.63 (2H, d, J=8Hz, Aromatic 3-H, 5-H), 7.92 (2H, d, J=8Hz, Aromatic 2-H, 6-H).

IR(KBr) ν $cm^{-1}$: 1348 ($SO_2$).

Reference Example 8 Synthesis of 3-phenyl-5,6,7,8-tetrahydro-2,1-benzoxathiin-1,1-dioxide

(1) Synthesis of 2-(cyclohexen-1-yl)-1-phenylethanone

To a solution of acetophenone (72 g, 0.6 mole) and cyclohexanone (59 g, 0.6 mole), a solution of sodium ethoxide (41 g) in ethanol (1000 ml) was added dropwise 0 - 5°C. The reaction was continued with stirring for 8 hours at the same temperature, then for 9 hours at 15 - 20°C. The reaction mixture was concentrated under reduced pressure, the residue was poured into a solution of conc. HCl (60 ml) in $H_2O$ (3500 ml), extracted with ethyl acetate (1000 ml x 2), and the organic layer was washed with $H_2O$ and dried over anhydrous $MgSO_4$. The dryer was filtered off, the filtrate was concentrated under reduced pressure, and the resultant residue (98 g) was distilled under reduced pressure to afford 15.6 g of 2-(cyclohexen-1-yl)-1-phenylethanone as a yellow viscous oil having a boiling point of 130 - 140°C/4 mmHg (532Pa).

$^1$HNMR δ ppm ($CDCl_3$): 1.36 - 2.54 (8H, m, cyclohexene ring $\underline{CH_2}$ x 4), 3.13 (2H, s, $\underline{CH_3}$), 5.57 (1H, s, cyclohexene ring C$\underline{H}$=), 7.38 - 7.62 (3H, m, Aromatic 3-H, 4-H, 5-H), 7.90 - 8.05 (2H, m, Aromatic 2-H, 6-H).

IR(Neat) ν $cm^{-1}$: 1685 (C=O)

(2) Synthesis of 3-phenyl-5,6,7,8-tetrahydro-2,1-benzoxathiin-1,1-dioxide

To a solution of 2-(cyclohexen-1-yl)-1-phenylethanone (7.8 g, 39 mole) obtained in above (1) in acetic anhydride (9.3 g, 92 mmole), sulfuric acid (3.8 g) was added dropwise at -10°C, and continued to stir for 7 hours at 0 - 5°C. Cold $H_2O$ (8 ml) was added to the reaction solution. The precipitate was filtered, washed with $H_2O$, petroleum ether and then cold methanol. The crude solid (3.9 g) was recrystallized from methanol to give 1.5 g of 3-phenyl-5,6,7,8-tetrahydro-2,1-benzoxathiin-1,1-dioxide as pale yellow crystals having a melting point of 132 - 136°C.

$^1$HNMR δ ppm ($CDCl_3$): 1.41 - 2.67 (8H, m, 2,1-benzoxathiin ring $CH_2$ x 4), 6.30 (1H, s, 2,1-benzoxathiin ring -C$\underline{H}$=), 7.31 - 7.47 (3H, m, Aromatic 3-H, 4-H, 5-H), 7.53 - 7.72 (2H, m, Aromatic 2-H, 6-H).

IR(KBr) ν $cm^{-1}$: 1365 ($SO_2$), 1180 ($SO_2$)

Reference Example 9 Synthesis of 4,6-dimethyl-1,2-oxathiin-2,4-dioxide

To a solution of 4-methyl-3-penten-2-one (22.6 g, 0.23 mole) in acetic anhydride (55.4 g, 0.54 mole), sulfuric acid (23.8 g, 0.24 mole) was added dropwise at -10 - -5°C, and reacted with stirring for 6 hours at 0 - 5°C. Cold $H_2O$ (250 ml) was added to the solution. The precipitate was filtered, washed with $H_2O$ and dried under reduced pressure. The crude solid (17.1 g) was recrystallized from benzene/n-hexane to give 10.8 g of 4,6-dimethyl-1,2-oxathiin-2,2-dioxide having a melting point of 68 - 70°C.

$^1$HNMR δ ppm ($CDCl_3$): 2.04 (3H, s, C$\underline{H_3}$), 2.15 (3H, s, C$\underline{H_3}$), 5.61 (1H, s, -C$\underline{H}$=), 6.26 (1H, s, -C$\underline{H}$=).

IR(KBr) ν cm$^1$: 1340 ($SO_2$), 1165 ($SO_2$).

Reference Example 10 Synthesis of 2,2-bis(p-toluene-sulfonyl)propane

A stream of dry hydrogen chloride was introduced into a solution of p-thiocresol (20 g, 0.16 mole) and acetone (4.7 g, 0.08 mole) in ethyl ether (50 ml) for 1.5 hours at 0 - 10°C. After reaction, the reaction mixture was washed with saturated sodium bicarbonate aqueous solution, and the solvent was removed. The residue was diluted with acetone (120 ml) and $H_2O$ (10 ml), sodium tungstate (500 mg) was added, 30% hydrogen peroxide (85 g) was added dropwise at 40 - 50°C, reacted with stirring for 3.5 hours under reflux. Cold $H_2O$ (400 ml) was poured into the reaction mixture. The precipitate was filtered, washed with $H_2O$ and dried. The crude solid (4.8 g) was recrystallized from ethanol to afford 2.5 g of 2,2-bis(p-toluenesulfonyl)(propane as white crystals having a melting point of 156 - 158.5°C.

$^1$HNMR δ ppm ($CDCl_3$): 1.70 (6H, s, C$\underline{H_3}$ x 2), 2.47 (6H, s, Ph-C$\underline{H_3}$ x 2), 7.38 (4H, d, J=8Hz, (Aromatic 3-H, 5-H) x 2), 7.89 (4H, d, J=8Hz), (Aromatic 2-H, 6-H) x 2).

IR(KBr) ν cm$^{-1}$: 1325 ($SO_2$), 1305 ($SO_2$).

Reference Example 11 Synthesis of p-tolyl p-chlorophenyl disulfone

(1) Synthesis of N-p-toluenesulfonyl-N'-p-chlorophenylsulfonylhydrazine

Using p-toluenesulfonylhydrazide (5.04 g, 27 mmole) obtained in Reference Example 7, (1) and p-chlorobenzenesulfonyl chloride (5.68 g, 27 mmole), reaction and treatment were carried out in the same manner as described in Reference Example 7, (2). The crude solid was recrystallized from methanol to give 4.52 g of N-p-toluenesulfonyl-N'-p-chlorophenylsulfonylhydrazine as white crystals.

$^1$HNMR δ ppm (DMSO-$d_6$): 2.40 (3H, s, $CH_3$), 7.37 - 7.77 (8H, m, Aromatic), 9.66 (1H, bs, $\underline{NH}$), 9.77 (1H, bs, $\underline{NH}$).

(2) Synthesis of p-tolyl p-chlorophenyl disulfone

Using N-p-toluenesulfonyl-N'-p-chlorophenylsulfonylhydrazine (2.00 g, 5.54 mmole) obtained in above (1), reaction and treatment were carried out in the same manner as described in Reference Example 7, (3). The crude solid was recrystallized from toluene to give 1.15 g of p-tolyl p-chlorophenyl disulfone as white prisms having a melting point of 161.0 - 161.5°C (decomp.).

$^1$HNMR δ ppm ($CDCl_3$): 2.52 (3H, s, C$\underline{H_3}$), 7.44 - 7.92 (8H, m, Aromatic).

IR(KBr) ν cm$^{-1}$: 1349 ($SO_2$).

Reference Example 12 Synthesis of p-tolyl isopropyl disulfone

(1) Synthesis of N-p-toluenesulfonyl-N'-isopropylsulfonylhydrazine

Using p-toluenesulfonylhydrazide (4.66 g, 0.025 mole) obtained in Reference Example 7, (1) and isopropylsulfonyl chloride (3.57 g, 0.025 mole), reaction and treatment were carried out in the same manner as described in Reference Example 7, (2). The crude solid (5.7 g) was chromatographed on silica gel (Wakogel C-200, manufactured by Wako Pure Chemical Industries, Ltd.) with n-hyexane/ethyl acetate (8-1 → 5/1 → 1/1) as eluent to afford 1.3 g of N-p-toluenesulfonyl-N'-isopropylsulfonylhydrazine as white crystals having a melting point of 187 - 190°C.

$^1$HNMR δ ppm ($CDCl_3$)/DMSO-$d_6$): 1.26 (6H, d, J=7Hz (C$\underline{H_3}$)$_2$ CH-), 2.36 (3H, s, C$\underline{H_3}$), 3.28 - 3.47 (1H, m, C$\underline{H}$), 7.25 (2H, d, J=8Hz, Aromatic 3-H, 5-H), 7.70 (2H, d, J=8H, Aromatic 2-H, 6-H), 8.49 (1H, d, J=2Hz, $\underline{NH}$), 9.49 (1H, d, J=2Hz, $\underline{NH}$).

IR(KBr) ν cm$^{-1}$: 3207 (NH), 1335 ($SO_2$).

(2) Synthesis of p-tolyl isopropyl disulfone

Using N-p-toluenesulfonyl-N'-isopropylsulfonylhydrazine (1.20 g, 0.041 mole) obtained in above (1), reaction and treatment were carried out in the same manne as described in Reference Example 7, (3). The crude solid was recrystallized from n-hexane/ethyl acetate to afford 0.35 g of p-tolyl isopropyl disulfone as white crystals, having mp. 150 - 152°C (decomp.).

$^1$HNMR δ ppm (DMSO-$d_6$): 1.39 (6H, d, J=7Hz, ($C\underline{H_3}$)$_2$ CH-), 2.45 (3H, s, $C\underline{H_3}$), 3.92 - 4.07 (1H, m, C$\underline{H}$), 7.59 (2H, d, J=8Hz, Aromatic 3-H, 5-H), 7.87 (2H, d, J=8Hz, Aromatic 2-H, 6-H).

IR(KBr) ν $cm^{-1}$: 1341 ($SO_2$).

Reference Example 13 Synthesis of p-tolyl benzyl disulfone

(1) Synthesis of N-p-toluenesulfonyl-N'-benzylsulfonylhydrazine

Using p-toluenesulfonylhydrazide (5.03 g, 0.027 mole) obtained in Reference Example 7, (1) and benzylsulfonyl chloride (5.15 g, 0.027 mole), reaction and treatment were carried out in the same manner as described in Reference Example 7, (2). The crude solid was recrystallized from ethanol to give 5.86 g of N-p-toluenesulfonyl-N'-benzylsulfonylhydrazine as white crystals, having mp. 183 - 185°C.

$^1$HNMR δ ppm (DMSO-$d_6$): 2.40 (3H, s, $C\underline{H_3}$), 4.34 (2H, s, $SO_2$, $C\underline{H_2}$-), 7.35 - 7.44 (7H, m, p-Tolyl 3-H, 5-H and Phenyl ring), 7.73 (2H, d, J=8.4Hz, p-Tolyl 2-H, 6-H), 9.38 (1H, s, $\underline{NH}$), 10.08 (1H, s, $\underline{NH}$)

IR(KBr) ν $cm^{-1}$: 3456 (NH), 3250 (NH), 1342 ($SO_2$), 1329 ($SO_2$).

(2) Synthesis of p-tolyl benzyl disulfone

Using N-p-toluenesulfonyl-N'-benzylsulfonylhydrazine (2.0 g, 5.8 mmole) obtained in above (1), reaction and treatment were carrie dout in the same manner as described in Reference Example 7, (3). The resultant crude solid was recrystallized from methanol to give 0.81 g of p-tolyl benzyl disulfone as white crystals having a melting point of 149 - 150.5°C (decomp.).

$^1$HNMR δ ppm (DMSO-$d_6$): 2.47 (3H, s, $C\underline{H_3}$), 5.13 (2H, s, $SO_2$ $C\underline{H_2}$-), 7.33 - 7.49 (5H, m, Phenyl ring), 7.58 (2H, d, J=8.4Hz, p-tolyl 3-H, 5-H), 7.85 (2H, d, J=8.4Hz, p-tolyl 2-H, 6-H).

IR(KBr) ν $cm^{-1}$: 1350 ($SO_2$)

Reference Example 14 Synthesis of p-tolyl p-methoxyphenyl disulfone

(1) Synthesis of N-p-toluenesulfonyl-N'-p-methoxybenzenesulfonylhydrazine

Using p-toluenesulfonylhydrazide (4.66 g, 0.025 mole) obtained in Reference Example 7, (1) and p-methoxybenzenesulfonyl chloride (5.17 g, 0.025 mole), reaction and treatment were carried out in the same manner as described in Reference Example 7, (2). The crude solid was recrystallized from acetone to give 2.75 g of N-p-toluenesulfonyl-N'-p-methoxybenzenesulfonylhydrazine as white needles, having mp. 209 - 210.5°C (decomp.).

$^1$HNMR δ ppm (DMSO-$d_6$): 2.39 (3H, s, $C\underline{H_3}$), 3.84 (3H, s, $C\underline{H_3}$ O), 7.10 (2H, d, J=8.8Hz, p-MeO-Ph 3-H, 5-H9, 7.38 (2H, d, J=8.4Hz, p-Tolyl 3-H, 5-H), 7.64 (2H, d, J=8.4Hz, p-Tolyl 2-H, 6-H), 7.68 (2H, d, J=8.8Hz, p-MeO-Ph 2-H, 6-H), 9.48 (1H, bs, $\underline{NH}$), 9.56 (1H, bs, $\underline{NH}$).

IR(KBr) ν $cm^{-1}$: 3206 (NH), 1341 ($SO_2$).

(2) Synthesis of p-tolyl p-methoxyphenyl disulfone

Using N-p-toluenesulfonyl-N'-p-methoxybenzenesulfonyl hydrazine (2.00 g, 5.61 mmole) obtained in above (1), reaction and treatment were carried out in the same manner as described in Reference Example 7, (3). The crude solid was recrystallized from acetone to give 1.10 g of p-tolyl p-methoxyphenyl disulfone as white crystals having a melting point of 174 - 176°C (decomp.).

$^1$HNMR δ ppm (DMSO-$d_6$): 2.47 (3H, s, $C\underline{H_3}$), 3.93 (3H, s, $C\underline{H_3}$ O), 7.26 (2H, d, J=8.8Hz, p-MeO-Ph 3-H, 5-H), 7.56 (2H, d, J=8.4Hz, p-Tolyl 3-H, 5-H), 7.69 (2H, d, J=8.4Hz, p-Tolyl 2-H, 6-H), 7.73 (2H, d, J=8.8Hz, p-MeO-Ph 2-H, 6-H).

IR(KBr) ν $cm^{-1}$: 1342 ($SO_2$).

Reference Example 15 Synthesis of p-tolyl octyl disulfone

(1) Synthesis of N-p-toluenesulfonyl-N'-octanesulfonylhydrazine

Using p-toluenesulfonylhydrazide (4.66 g, 0.025 mole) obtained in Reference Example 7, (1) and octanesulfonyl chloride (5.32 g, 0.025 mole), reaction and treatment were carride out in the same manner as described in Reference Example 7, (2). The crude solid was recrystallized from n-hexane/methylene dichloride to give 3.65 g of N-p-toluenesulfonyl-N'-octanesulfonylhydrazine as white crystals having a melting point of 95 - 98°C.

$^1$HNMR δ ppm (DMSO-$d_6$): 0.89 (3H, t, J=6.7Hz, $-(CH_2)_7C\underline{H_3}$), 1.12 - 1.43 (10H, m, $-CH_2\ (C\underline{H_2})_5\ CH_3$), 1.53 - 1.72 (2H, m, $-SO_2\ CH_2\ C\underline{H_2}\ CH_2-$), 2.40 (3H, s, $C\underline{H_3}$ -Ph), 3.01 (2H, t, J=7.6Hz, $SO_2\ C\underline{H_2}\ CH_2-$), 7.42 (2H, d, J=8.1Hz, Aromatic 3-H, 5-H), 7.64 (2H, d, J=8.1Hz, Aromatic 2-H, 6-H), 9.20 (1H, d, J=2.4Hz, $\underline{NH}$), 9.91 (1H, d, J=2.4Hz, NH).

IR(KBr) ν $cm^{-1}$: 3236 (NH), 1346 ($SO_2$), 1325 ($SO_2$).

(2) Synthesis of p-tolyl octyl disulfone

Using N-p-toluenesulfonyl-N'-octanesulfonylhydrazine (2.00 g, 5.4 mmole) obtained in above (1), reaction and treatment were carried out in the same manner as described in Reference Example 7, (3). The crude solid was recrystallized from n-hexane/methylene dichloride to give 1.05 g of p-tolyl octyl disulfone as white needles having a melting point of 56.5 - 57.5°C.

$^1$HNMR δ ppm (DMSO-$d_6$): 0.86 (3H, t, J=6.6Hz, $-(CH_2)_7\ CH_3$), 1.15 - 1.47 (10H, m, $-CH_2(C\underline{H_3})_5CH_3$), 1.74 (2H, m, J=5.9Hz, $SO_2\ CH_2\ C\underline{H_2}\ CH_2-$), 2.50 (3H, s, $CH_3$ -Ph), 3.69 (2H, t, J=5.1Hz, $-SO_2\ C\underline{H_2}\ CH_2-$), 7.63 (2H, d, J=8.1Hz, Aromatic 3-H, 5-H), 7.92 (2H, d, J=8.1Hz, Aromatic 2-H, 6-H).

IR(KBr) ν $cm^{-1}$: 1346 ($SO_2$).

Example 1

Using the following resist material, a pattern was formed as mentioned below.

| | |
|---|---|
| Poly[p-(1-ethoxyethoxy)styrene-p-hydroxystyrene] (polymer of Synthesis Example 1) | 20.0 g |
| Diphenyldisulfone (acid generator of Reference Example 4) | 0.1 g |
| Diethylene glycol dimethyl ether | 80.0 g |

Figs. 1A and 1B are cross-sectional views explaining the process for forming a fine pattern according to the present invention.

The resist material having the above composition was spin coated (2000 rpm, 60 sec.) on a semiconductor substrate 11 and prebaked at 90°C or 90 seconds on a hot plate to form a resist film 12 having a film thickness of 1.0 μm. The resist film was imagewisely exposed to electron beams 13 at an accelerating voltage of 50 KeV and dosage of 0.1 to 300 μC/$cm^2$, followed by baking at 100°C for 90 seconds on the hot plate. Then, development was conducted using an alkaline developer (2.38% TMAH aqueous solution) for 60 seconds to give a positive-working pattern.

Fig. 2 shows a sensitivity curve showing a relationship between the normalized remaining film thickness and the dose in the pattern formation. The sensitivity curve shows that sensitivity of this resist film is about 0.5 μC/$cm^2$.

On the other hand, when this resist film was imagewisely exposed to electron beams at an accelerating voltage of 50 KeV and dosage of 1 μC/$cm^2$ (Fig. 1A) and baked at 100°C for 90 seconds, followed by development for 60 seconds, there was obtained a precise, fine positive-working pattern 12 p (Fig. 1B). The resulting minimum pattern had a vertical shape with 0.2 μm line and space, i.e., the fine resist pattern with high resolution.

Example 2

The resist material used in this Example had the following composition:

| | |
|---|---|
| Poly[p-(1-methoxy-1-methoxyethoxy)styrene/p-hydroxystyrene] (polymer of Synthesis Example 7) | 20.0 g |
| p-Tolyl n-butyldisulfone (acid generator of Reference Example 7) | 0.4 g |
| Diethylene glycol dimethyl ether | 80.0 g |

The resist film of 1.0 μm thick obtained in the same manner as described in Example 1 using the above-mentioned resist material was imagewisely exposed to electron beams at an accelerating voltage of 50 keV and dosage of 0.1 to 300 μC/cm², followed by baking at 100°C for 90 seconds. After developing with a conventional organic alkaline developer for 60 second, a positive-working resist pattern was obtained.

The sensitivity curve showing a relationship between the normalized remaining film thickness and the dose is shown in Fig. 3. From this sensitivity curve, the sensitivity of this resist film is about 0.8 μC/cm².

When this resist film was imagewisely exposed to electron beams at an accelerating voltage of 50 KeV and dosage of 1 μC/cm² and baked at 100°C for 90 seconds, followed by development for 60 seconds, there was obtained a precise, fine positive-working resist pattern. The resulting minimum pattern had a vertical shape with 0.2 μm line and space, i.e. the fine resist pattern with high resolution.

Example 3

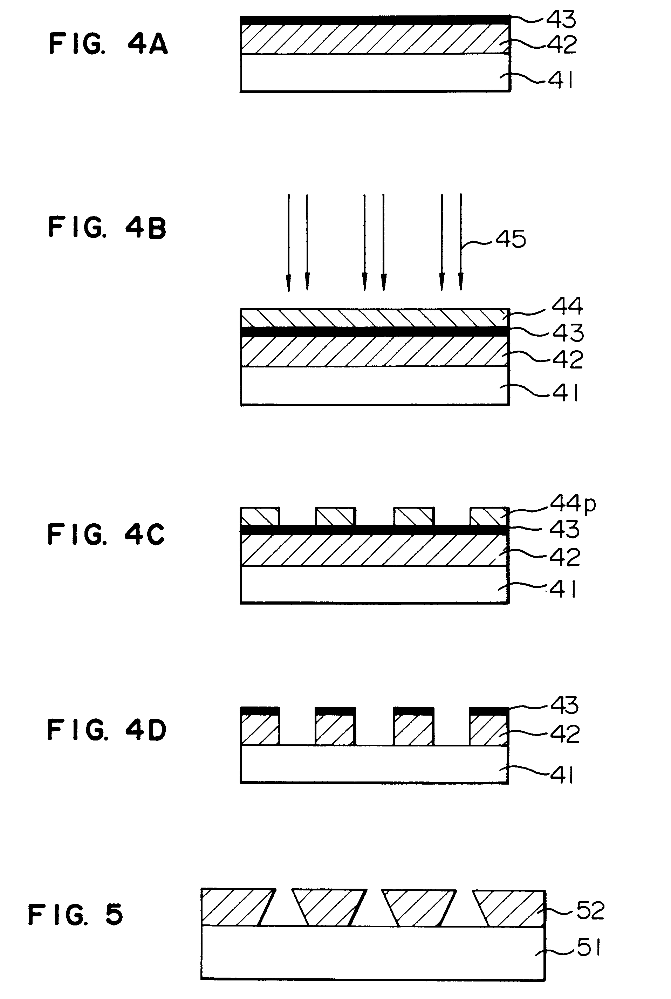

The process for forming a resist pattern of this Example is explained referring to Figs. 4A to 4D.

On a semiconductor substrate 41, an organic high polymer film forming material containing a novolak resin as a major component was coated and subjected to heat treatment at 200°C for 20 minutes to form an organic underlying film 42 with a film thickness of 2 μm (Fig. 4A). On the underlying film, SOG (spin on glass) was coated and heat treated at 200°C to form an intermediate layer 43 with 0.2 μm thick. Then, the resist material of Example 1 was spin coated (4000 rpm, 60 sec.) on the intermediate layer and heat treated at 90°C for 90 seconds to form an upper resist film 44 with 0.5 μm thick. The resist film was imagewisely exposed to electron beams 45 at an accelerating voltage of 20 KeV and dosage of 1.5 μC/cm² (Fig. 4B). After heat treating the substrate at 100°C for 90 seconds, development was conducted in a conventional manner using an organic alkaline developer for 60 seconds to obtain an upper resist pattern 44p (Fig. 4C). Then, using the resulting resist pattern as a mask, etching of the intermediate layer was conducted. The selection rate of the upper resist against the intermediate layer was about 3. Thus, the pattern was precisely transferred to obtain an intermediate layer pattern. Further, using the resulting intermediate layer pattern as a mask, etching of the organic underlying film was conducted to obtain a 0.2 μm vertical fine pattern (Fig. 4D).

As mentioned above, by using the resist material of the present invention as the upper layer resist in the three-layer resist process, fine pattern with high sensitivity and high resolution can be formed stably.

Example 4

After forming an organic underlying film and an inorganic intermediate film on a semiconductor substrate in the same manner as described in Example 3, the resist material of Example 2 was spin coated (4000 rpm, 60 seconds) on the intermediate layer and heat treated at 90°C for 90 seconds to form an upper resist film of 0.5 μm thick. The resist film was imagewisely exposed to electron beams at an accelerating voltage of 20 KeV and dosage of 1.5 μC/cm². After heat treating the substrate at 100°C for 90 seconds, development was conducted in a conventional manner using an organic alkaline developer for 60 seconds to obtain an upper layer resist pattern. Then, using the resulting resist pattern as a mask, etching of the intermediate layer was conducted. The selection rate of the upper resist against the intermediate layer was about 3. Thus, the pattern was precisely transferred to obtain an intermediate layer pattern. Further, using the resulting intermediate layer pattern as a mask, etching of the organic underlying film was conducted to obtain a 0.2 μm vertical fine pattern.

Examples 5 - 15

Resist compositions were prepared according to the respective recipes shown in Table 1.

Table 1

| Example No. | Resist composition | |
|---|---|---|
| 5 | Poly[p-(1-ethoxyethoxy)styrene/p-hydroxystyrene] (Polymer of Synthesis Example 3) | 20.0 g |
| | p-tolyl benzyl disulfone (Acid generator of Reference Example 13) | 0.4 g |
| | Diethyleneglycol dimethylether | 80.0 g |
| 6 | Poly[p-(1-methoxy-methylethoxy)-styrene/p-hydroxystyrene] (Polymer of Synthesis Example 7) | 20.0 g |
| | p-Tolyl p-chlorophenyl disulfone (Acid generator of Reference Example 11) | 0.2 g |
| | Propyleneglycol monomethylether acetate | 80.0 g |
| 7 | Poly[p-(1-ethoxyethoxy)styrene/p-tert-butoxystyrene/p-hydroxystyrene] (Polymer of Synthesis Example 12) | 20.0 g |
| | p-Tolyl isopropyl disulfone (Acid generator of Reference Example 12) | 0.3 g |
| | Propyleneglycol monoethylether acetate | 80.0 g |
| 8 | Poly[p-(1-ethoxyethoxy)styrene/p-hydroxystyrene] (Polymer of Synthesis Example 11) | 15.0 g |
| | p-Tolyl phenyl disulfone (Acid generator of Reference Example 5) | 0.2 g |
| | Diethyleneglycol dimethylether | 75.0 g |

(to be continued)

Table 1 (cont'd)

| | | |
|---|---|---|
| 9 | Poly[p-(1-n-butoxyethoxy)styrene/p-hydroxystyrene] (Polymer of Synthesis Example 8) | 20.0 g |
| | p-Tolyl p-methoxyphenyl disulfone (Acid generator of Reference Example 14) | 0.4 g |
| | Ethyl lactate | 80.0 g |
| 10 | Poly-[p-(1-ethoxyethoxy)styrene/p-hydroxystyrene/fumaronitrile] (Polymer of Synthesis Example 9) | 20.0 g |
| | p-Tolyl octyl disulfone (Acid generator of Reference Example 15) | 0.4 g |
| | Cyclohexanone | 80.0 g |
| 11 | Poly[p-(1-ethoxyethoxy)styrene/p-hydroxystyrene] (Polymer of Synthesis Example 11) | 20.0 g |
| | 3-Phenyl-5,6,7,8-tetrahydro-2,1-benzoxathiin-1,1-dioxide (Acid generator of Reference Example 8) | 0.4 g |
| | Diethyleneglycol dimethylether | 80.0 g |
| 12 | Poly[(1-methoxyethoxy)styrene/p-hydroxystyrene] (Polymer of Synthesis Example 6) | 20.0 g |
| | 4,6-Dimethyl-1,2-oxathiin-2,2-dioxide (Acid generator of Reference Example 9) | 0.5 g |
| | Diethyleneglycol dimethylether | 80.0 g |
| 13 | Poly[p-(1-ethoxyethoxy)styrene/p-hydroxystyrene] (Polymer of Synthesis Example 11) | 20.0 g |
| | 2,2-Bis(p-toluenesulfonyl)propane (Acid generator of Reference Example 10) | 0.4 g |
| | Diethyleneglycol dimethylether | 80.0 g |
| | | |

(to be continued)

Table 1 (cont'd)

| | | |
|---|---|---|
| 14 | Poly[p-(1-ethoxyethoxy)styrene/p-hydroxystyrene/tert-butyl methacrylate] (Polymer of Synthesis Example 10) | 20.0 g |
| | p-Tolyl phenyl disulfone (Acid generator of Reference Example 5) | 0.2 g |
| | Propyleneglycol monomethylether acetate | 80.0 g |
| 15 | Poly[p-(1-ethoxyethoxy)styrene/p-hydroxystyrene] (Polymer of Synthesis Example 5) | 20.0 g |
| | p-Tolyl octyl disulfone (Acid generator of Reference Example 15) | 0.2 g |
| | Propyleneglycol monomethylether acetate | 80.0 g |

Pattern formation was carried out in the same manner as in Example 1 except for using each resist composition prepared in the above. The results obtained are shown in Table 2.

Table 2

| Example No. | Acceleration Voltage | Exposure Dose | Resolution | Pattern Profile |
|---|---|---|---|---|
| 5 | 50 KeV | 1 μC/cm$^2$ | 0.2 μm Line and Space | Good shape |
| 6 | 50 KeV | 1 μC/cm$^2$ | 0.2 μm Line and Space | Good shape |
| 7 | 30 KeV | 1 μC/cm$^2$ | 0.22 μm Line and Space | Good shape |
| 8 | 50 KeV | 1.5 μC/cm$^2$ | 0.2 μm Line and Space | Good shape |
| 9 | 50 KeV | 1 μC/cm$^2$ | 0.2 μm Line and Space | Good shape |
| 10 | 30 KeV | 1 μC/cm$^2$ | 0.22 μm Line and Space | Good shape |
| 11 | 50 KeV | 1 μC/cm$^2$ | 0.22 μm Line and Space | Good shape |
| 12 | 50 KeV | 1.5 μC/cm$^2$ | 0.22 μm Line and Space | Good shape |
| 13 | 50 KeV | 1.5 μC/cm$^2$ | 0.2 μm Line and Space | Good shape |
| 14 | 50 KeV | 1.5 μC/cm$^2$ | 0.22 μm Line and Space | Good shape |
| 15 | 50 KeV | 1 μC/cm$^2$ | 0.2 μm Line and Space | Good shape |

As is clear from Table 2, in any of Examples 5 to 15, a positive pattern could be formed as in Example 1, and the resolution of 0.2 to 0.22 μm line and space could be obtained with good shape, as in Example 1.

Comparative Example 1

A resist material having the following compposition was prepared:

| | |
|---|---|
| Poly(p-tert-butoxycarbonyloxystyrene-p-hydroxystyrene) (Polymer of Reference Example 3) | 20.0 g |
| Triphenylphosphonium hexafluorophosphate | 0.1 g |
| Diethylene glycol dimethyl ether | 80.0 g |

A resist film of 1.0 μm thick was obtined using the above-mentioned composition in the same manner as described in Example 1. The resist film was imagewisely exposed to electron beams at an accelerating voltage of 50 KeV and dosage of 1 $\mu C/cm^2$ to form a positive-working pattern in the same manner as described in Example 1. The obtained pattern showed undesirable adverse trapezoids as shown in Fig. 5, wherein numeral 52 denotes the resist pattern and numeral 51 denotes the semiconductor substrate.

Comparative Example 2

A resist material having the following composition was prepared:

| | |
|---|---|
| Poly(p-tetrahydropyranyloxystyrene-p-hydroxystyrene) (Polymer of Reference Example 1) | 20.0 g |
| Diphenyliodonium hexafluorophosphate | 0.1 g |
| Diethylene glycol dimethyl ether | 80.0 |

A resist film of 1.0 μm thick was obtained using the above-mentioned composition in the same manner as described in Example 1. The resist film was image-wisely exposed to electron beams at an accelerating voltage of 30 KeV and dosage of 1 $\mu C/cm^2$ to form a positive-working pattern in the same manner as described in Example 1. The obtained pattern showed undesirable adverse trapezoids as in Comparative Example 1.

As mentioned above, by using the resist material of the present invention as electron beam resists, it is possible to form a positive-working resist pattern maintaining high sensitivity, high resolution and stable pattern dimension. Further, since the polymer in the resist material has a protective group which can easily be removed in the presence of an acid, extremely high sensitivity can be obtained by combining with the special acid generators. Thus, the throughput can be increased. In addition, since an alkaline aqueous solution can be used as a developers no swelling at the time of development takes place, and there are no problems in the environments and human bodies. Thus, according to the present invention, fine patterns can be formed easily and production of ultra-high density integrated circuits becomes very easy.

Further, the resist material of the present invention exhibits the best effects when electron beams are applied, but can also be used sufficiently when deep UV light such as KrF excimer laser light, etc., and X-rays are applied.

## Claims

**1.** A resist material comprising
(a) a polymer represented by the formula:

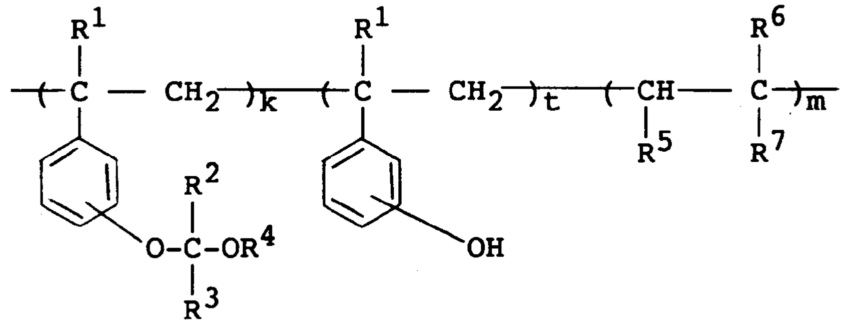

[I]

wherein $R^1$ is a hydrogen atom or a methyl group; $R^2$ and $R^3$ are independently a hydrogen atom or a straight, branched or cyclic alkyl group having 1 to 6 carbon atoms, provided that $R^2$ and $R^3$ cannot be hydrogen atoms at the same time; or $R^2$ and $R^3$ can form together a methylene linkage having 2 to 5 carbon atoms; $R^4$ is a straight, branched or cyclic alkyl group having 1 to 10 carbon atoms, a straight, branched or cyclic haloalkyl group having 1 to 6 carbon atoms, or an aralkyl group having 7 to 10 carbon atoms; $R^5$ is a hydrogen atom or a cyano group; $R^6$ is a hydrogen atom or a methyl group; $R^7$ is a hydrogen atom, a cyano group, -COOY in which Y is a straight, branched or cyclic alkyl group having 1 to 6 carbon atoms, or a group of the formula:

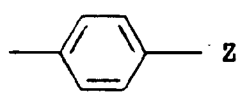

[II]

in which Z is a hydrogen atom, a halogen atom, a straight or branched alkyl group having 1 to 10 carbon atoms, or a straight, branched or cyclic alkoxy group having 1 to 10 carbon atoms, or $R^4$ and $R^5$ can form together a group of the formula: -CO-O-CO-; k and t are independently an integer of 1 or more, provided that $0.1 \leqq k/(k+t) \leqq 0.9$; and m is zero or an integer of 1 or more, provided that when m is an integer of 1 or more, $0.05 \leqq m/(k+t+m) \leqq 0.50$,

(b) an acid generator which can generate an acid upon exposure to electron beams, and

(c) a solvent capable of dissolving the components (a) and (b).

**2.** A resist material according to Claim 1, wherein the acid generator (b) is a compound represented by the formula:

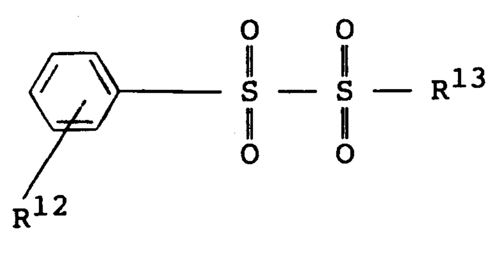

[III]

wherein $R^{12}$ is a hydrogen atom, a halogen atom, a straight, branched or cyclic alkyl group having 1 to 10 carbon atoms or a straight, branched or cyclic alkoxy group having 1 to 10 carbon atoms; and $R^{13}$ is a straight, branched or cyclic alkyl group having 1 to 8 carbon atoms, a phenyl group, an alkyl-substituted phenyl group, a halogen-substituted phenyl group, a benzyl group or an alkoxy-substituted phenyl group.

**3.** A resist material according to Claim 1, wherein the acid generator (b) is a compound represented by the formula:

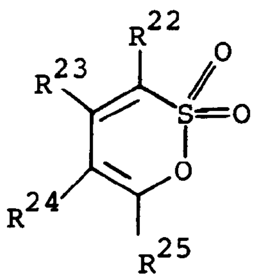

[IV]

wherein $R^{22}$, $R^{23}$, $R^{24}$ and $R^{25}$ are independently a hydrogen atom, a halogen atom, a straight, branched or cyclic alkyl group having 1 to 10 carbon atoms, a haloalkyl group having 1 to 10 carbon atoms, an alkoxyalkyl group having 2 to 10 carbon atoms, an aralkyl group having 7 to 10 carbon atoms, a phenyl group, a substituted phenyl group, in which the substituent being one or more halogen atoms, straight, branched or cyclic alkyl groups having 1 to 10 carbon atoms, straight, branched or cyclic alkoxy groups having 1 to 10 carbon atoms, nitro groups or cyano groups, and $R^{22}$ together with $R^{23}$, $R^{23}$ together with $R^{24}$, adn $R^{24}$ together with $R^{25}$, can independently form an alicyclic ring, a heteroalicyclic ring, an aromatic ring or a heteroaromatic ring.

**4.** A resist material according to Claim 1, wherein the acid generator (b) is a compound represented by the formula:

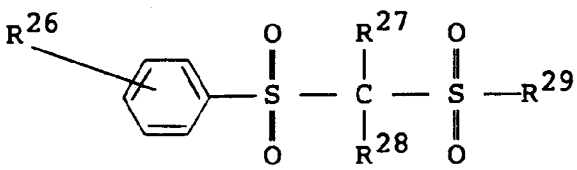

[V]

wherein $R^{26}$ is a hydrogen atm, a halogen atom, a straight, branched or cyclic alkyl group having 1 to 10 carbon atoms, or a straight, branched or cyclic alkoxy group having 1 to 10 carbon atoms; $R^{27}$ is a hydrogen atom, or an alkyl group having 1 to 3 carbon atoms; $R^{28}$ is an alkyl group having 1 to 3 carbon atoms; and $R^{29}$ is a straight, branched or cyclic alkyl group having 1 to 10 carbon atoms, an aralkyl group having 7 to 10 carbon atoms, a phenyl group, a substituted phenyl group in which the substituent being one or more halogen atoms, straight, branched or cyclic alkyl groups having 1 to 10 carbon atoms or straight, branched or cyclic alkoxy groups having 1 to 10 carbon atoms.

**5.** A process for forming a fine pattern, which comprises
(i) a step of coating the resist material of Claim 1 on a semiconductor substrate, followed by heat treatment for forming a resist film,
(ii) a step of exposing the resist film to electron beams to image a pattern, followed by heat treatment depending on necessity, and
(iii) a step of developing the resulting resist film with an alkaline aqueous solution to form a positive-working pattern.

**6.** A process for forming a fine pattern, which comprises
(i) a step of coating an organic high polymer solution on a semiconductor substrate, followed by heat treatment to form an underlying film,
(ii) a step of forming an inorganic intermediate film on the underlying film,
(iii) coating the resist material of Claim 1 on the intermediate film, followed by heat treatment to form a resist film,
(iv) a step of exposing the resist film to electron beams to image a pattern, followed by heat treatment depending on necessity,
(v) a step of developing the resist film with an alkaline aqueous solution to form a positive-working pattern,
(vi) a step of masking the resulting resist pattern, followed by etching of the intermediate film, and
(vii) a step of masking the resulting pattern, followed by etching the underlying film.

**7.** A process according to Claim 6, wherein the organic high polymer solution is a solution containing a novolak resin as a major component.

**8.** A process according to Claim 6, wherein the inorganic intermediate film is a silicon oxide film or a spin-on-glass.

**9.** A resist material according to Claim 1, wherein m in the polymer of the formula [I] is zero.

**10.** A resist material according to Claim 1, wherein the monomer unit of the formula:

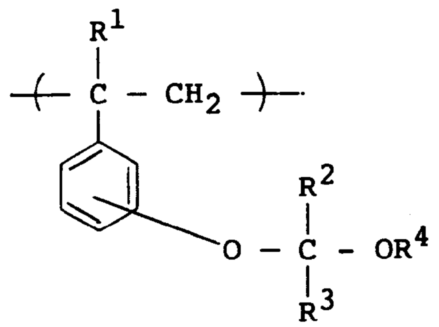

[VII]

in the polymer of the formula [I] is derived from at least one monomer selected from the group consisting p- and m-hydroxystyrene derivatives having a functional group of the formula:

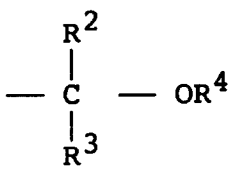

[VI]

wherein $R^2$, $R^3$ and $R^4$ are as defined in Claim 1, and p- and m-hydroxy-α-methylstyrene derivatives having a functional group of the formula [VI].

**11.** A resist material according to Claim 10, wherein the monomer is at least one member selected from the group consisting of p- and m-1-methoxy-1-methyl-ethoxystyrene, p- and m-1-benzyloxy-1-methylethoxystyrene, p- and m-1-ethoxyethoxystyrene, p- and m-1-methoxyethoxystyrene, p- and m-1-n-butoxyethoxystyrene, p- and m-1-isobutoxyethoxystyrene, p- and m-1-(1,1-dimethylethoxy)-1-methylethoxystyrene, p- and m-1-(1,1-dimethylethoxy)ethoxystyrene, p- and m-1-(2-chloroethoxy)ethoxystyrene, p- and m-1-cyclohexyloxyethoxy-styrene, p- and m-1-(2-ethylhexyloxy)ethoxystyrene, p-and m-1-ethoxy-1-methylethoxystyrene, p- and m-1-n-propoxyethoxyethoxystyrene, p- and m-1-ethoxypropoxystyrene, p- and m-1-methoxybutoxystyrene, and p- and m-1-methoxycyclohexyloxystyrene.

FIG. 1A

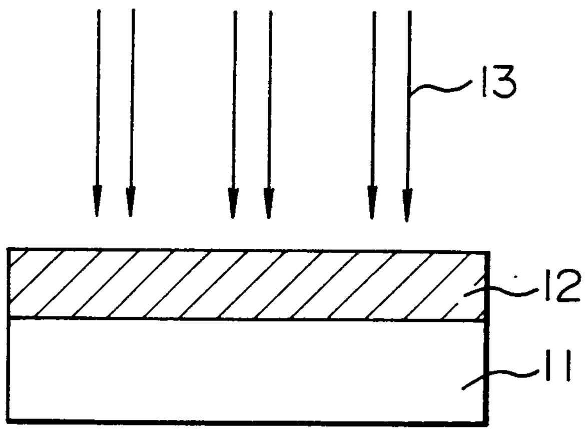


FIG. 1B

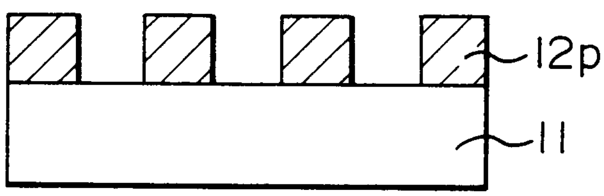

FIG. 2

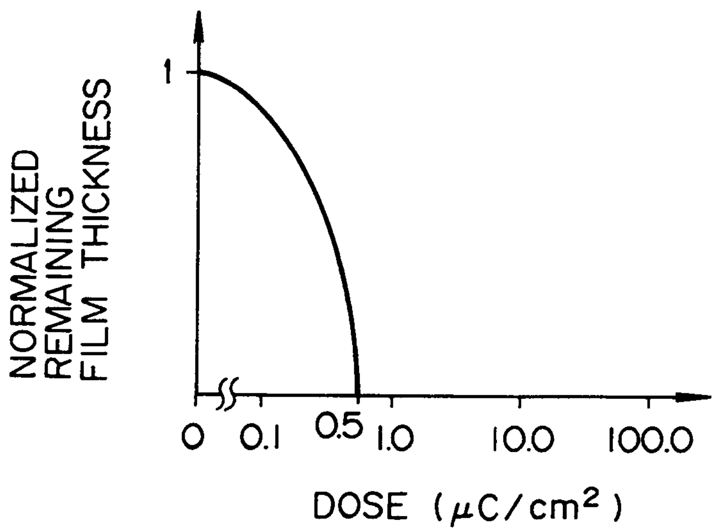
NORMALIZED REMAINING FILM THICKNESS
1
0
0.1
0.5
1.0
10.0
100.0
DOSE (μC/cm²)

FIG. 3

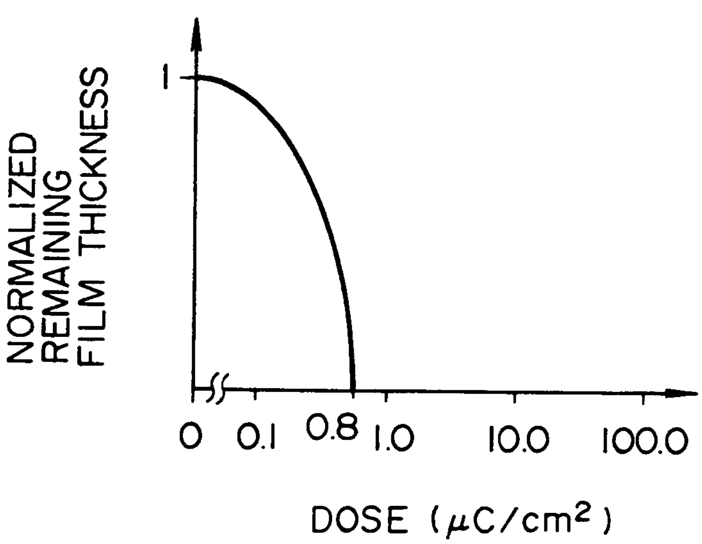
NORMALIZED REMAINING FILM THICKNESS
1
0
0.1
0.8
1.0
10.0
100.0
DOSE (μC/cm²)

FIG. 4A

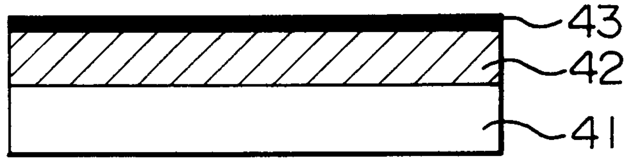


FIG. 4B

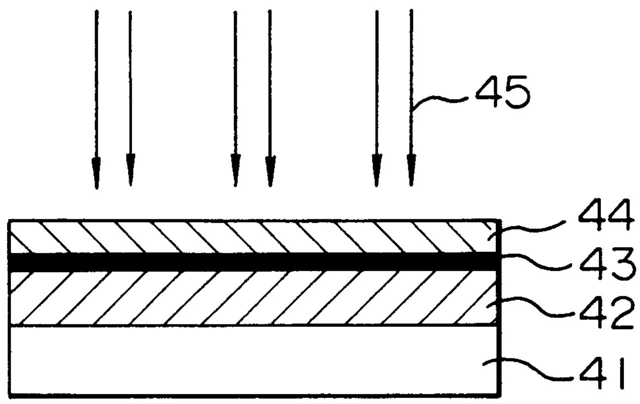


FIG. 4C

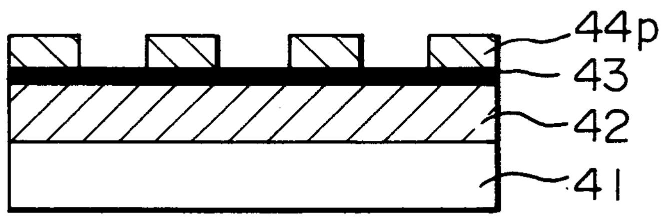


FIG. 4D

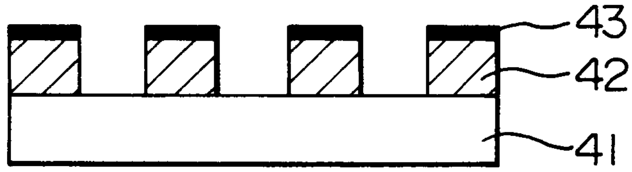


FIG. 5